Europäisches Patentamt

European Patent Office

Office européen des brevets

(11) Publication number: **0 153 478**
**B1**

(12) **EUROPEAN PATENT SPECIFICATION**

(45) Date of publication of patent specification: **14.02.90**

(21) Application number: **84115606.0**

(22) Date of filing: **17.12.84**

(51) Int. Cl.⁵: **G 01 R 27/28**

(54) Signal separation circuit for a radio frequency (RF) network analyzer.

(30) Priority: **09.01.84 US 569111**

(43) Date of publication of application:
**04.09.85 Bulletin 85/36**

(45) Publication of the grant of the patent:
**14.02.90 Bulletin 90/07**

(84) Designated Contracting States:
**DE FR GB**

(56) References cited:
**DE-A-2 637 775**
**US-A-3 968 427**

**R.C.A. REVIEW, vol. 42, no. 4, December 1981, Princeton, New Jersey, USA; B.S. PERLMAN "Automatic S-parameter characterization of microwave devices and circuits using a phase locked automatic network analyser (PLANA)", pages 770-781**

**IEE PROCEEDINGS-H, vol. 127, no. 2nd April 1980, Herts, GB; P.R. RIGG et al. "Low-cost computer-based-time domain microwave network-analyser", pages 107-111**

(73) Proprietor: **Hewlett-Packard Company**
**Mail Stop 20 B-O 3000 Hanover Street**
**Palo Alto California 94304 (US)**

(72) Inventor: **Donecker, S. Bruce**
**5920 Burnside Rd**
**Sebastopol, CA 95472 (US)**
Inventor: **Stewart, Ronald D.**
**3578 Aaron Drive**
**Santa Rosa, CA 95404 (US)**
Inventor: **Frederick, Wayne L.**
**5634 Crystal Court**
**Santa Rosa, CA 95404 (US)**

(74) Representative: **Patentanwälte Kohler - Schwindling - Späth**
**Hohentwielstrasse 41**
**D-7000 Stuttgart 1 (DE)**

(56) References cited:
**E.D.N. ELECTRICAL DESIGN NEWS, vol. 27, no. 18, September 1982, Massachusetts, USA; J.L. HARTKE "PIN-diode switches excel in wide-bandwidth use", pages 161-166**

Courier Press, Leamington Spa, England.

## Description

The present invention relates to a signal separation circuit for a radio frequency (RF) network analyzer. An example of such a signal separation circuit is the Hewlett-Packard Model 8503A S-Parameter Test Set. This instrument is an accessory for radio frequency network analyzers which facilitates measurement of the S-paramaters (scattering parameters) of a device under test (DUT) over a range of frequencies.

In general, an RF network analysis measurement system contains several separate modules. First is an RF source to provide a stimulus to a device under test (DUT). Second is a signal separation circuit, or test set, for routing the stimulus to the DUT and for sampling the energy that is reflected from, or transmitted through, the DUT. Also, energy is sampled from the signal that is incident upon the DUT in order to provide a reference for all relative measurements. Third is a tuned receiver to convert the resulting signals to an intermediate frequency (IF) for further processing. In vector network analyzers both the magnitude and phase relationships of the original signals must be maintained through the frequency conversion to IF to provide usable measurements. Fourth is a detector to detect the magnitude and phase characteristics of the IF signals, and fifth is a display on which to present the measurement results.

In the known signal separation circuit, a radio frequency stimulus received at an RF input port is routed to two test ports for connection to the DUT by a reverting (double-pole double-throw) switch. With the reversing switch set to its first position, the DUT receives the stimulus from test port 1 and the reponse of the DUT (the transmitted signal) is incident on test port 2; with the reversing switch set to its second position, the DUT receives the stimulus from test port 2 and the transmitted signal is incident on test port 1. The circuit includes two directional bridges which are coupled to the test ports and configured to sample IF signals that are incident on the test ports from the DUT. Thus both the reflected and the transmitted part of the RF stimulus is sampled and may be routed to the network analyzer for evaluation with either setting of the reversing switch. This enables a measurement of the S-parameters of the DUT without a need for manual reconnections.

Measurement accuracy may be improved in a computer controlled system by a process known as vector error correction where a set of calibration devices with known characteristics is measured and a set of equations is solved to determine the errors associated with the network analyzer itself. This calibration model is then stored in the computer for later correction of data measured on an unknown device.

With the known signal separation circuit, however, the electrical characteristics of the path between the reference port and the device under test may vary in a non-repeatable fashion on each reversal of the signal flow to the device under test because of non-repeatability of the reversing switch, which may cause errors not accounted for in previous calibration of the system.

Relative to this prior art, it is the object of the present invention to improve the known signal separation circuit in such a way that a complete measurement of the S-parameters of a device under test may be performed without a loss of calibration.

This object is met by the invention as defined by claim 1. The test set architecture comprising an electronic switch in the signal separation means and selection means eliminates the extensive RF switching needed in previous test sets, removing the significant uncertainties caused by the lack of repeatability of mechanical switches.

Embodiments of the invention which include features of the subclaims, allow a fully error corrected measurement of the four vector S-parameters, and of the vector transmission and reflection parameters, in "real time". The use of a PIN diode switch as known per se from "EDN Electrical Design News", Vol. 27, No. 18 (1982) pages 161 to 166, renders the circuit especially simple and fast. Vector testing using a single set up of a DUT can be performed across a broadband frequency range from RF to millimeter bands. Dynamic accuracies of 0.05 dB in magnitude and 0.3 degrees in phase can be accomplished for a device with 50 dB of insertion loss. An overall dynamic range of 100 dB, resolutions of 0.001 dB in magnitude, 0.01 degrees in phase, and 10 picoseconds in group delay, and corresponding measurement stabilities are attained depending on the particular frequency range and signal separation circuit used.

The signal separation circuits, or test sets, according to the present invention incorporate broadband signal separation devices, balanced broadband power splitters, and high conversion efficiency samplers with flat frequency response and low crosstalk, and provide optimized performance for different frequency ranges and connector types. A dedicated interface provides control from a main network analyzer.

An embodiment of the invention will now be described in detail with reference to the accompanying drawings.

Figure 1 shows a simplified block diagram of an RF vector network analyzer;

Figures 2a and 2b shows a schematic and cross sectional view respectively of a wideband RF directional bridge for use in an embodiment of the present invention;

Figures 3 through 6 show detailed block diagrams of four test sets as shown in figure 1;

Figure 7.1 through 7.24 show detailed schematics for selected parts of the block diagrams shown in figures 3 through 6;

Figures 8.1 through 8.6 show a detailed block diagram of the IF/detector section of the vector network analyzer shown in figure 1;

Figures 9.1 through 9.6 show a block diagram and the detailed equations used for adjusting offset and gain errors in the IF/detector section of the vector network analyzer shown in figure 1; and

Figures 10.1 through 10.34 show detailed schematic for selected parts of the block diagram shown in figures 8.1 through 8.6.

Description of the Block Diagram

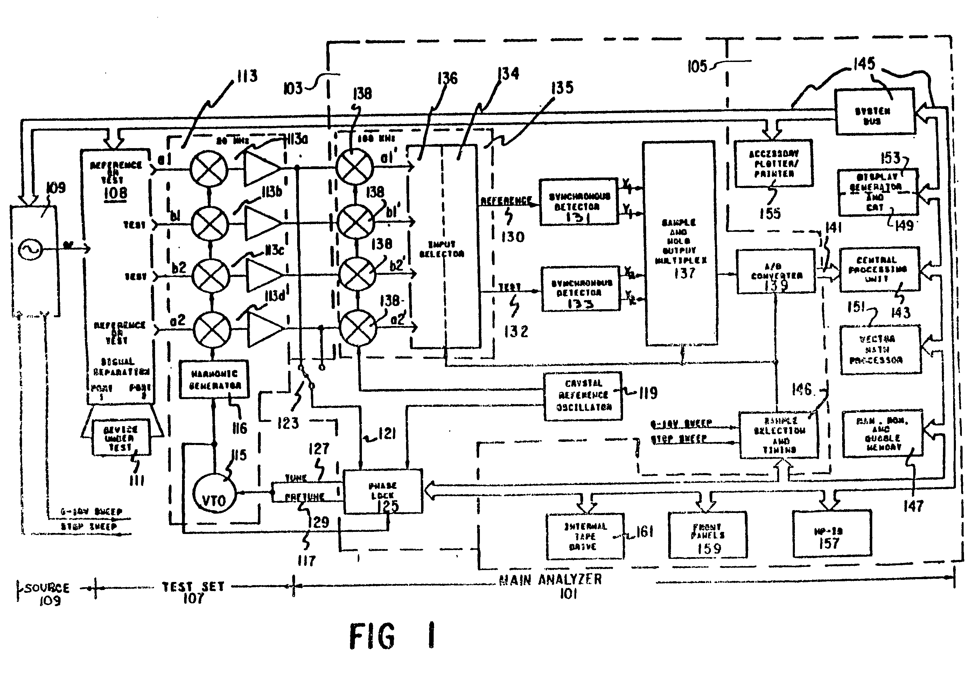

Figure 1 shows a block diagram of an RF vector network analyzer system. The measurement system consists first of a main network analyzer 101 with a second IF/detector section 103 and a data processor/display section 105. The main network analyzer 101 is fed by one of four configured test sets 107 which provide the signal separation circuitry 108 and first IF frequency conversion circuitry 113 for reflection/transmission (one incident signal) or S-parameter (two incident signals) measurements up to either 18 or 26.5 GHz. The frequency converter 113 alone is also available to permit the addition of user supplied signal separation devices 108 for specially configured test needs. The third main component of the measurement system is a compatible RF source 109 such as an HP 8340A synthesized sweeper, available from the Hewlett-Packard Co., Palo Alto, California, which can be used in either a stepped frequency mode, in which synthesizer class frequency accuracy and repeatability can be obtained by phase locking the source 109 at each of the over 400 frequency steps over the frequency range selected by the main analyzer 101 or the swept frequency mode for applications where extreme frequency range, high stability, and spectral purity are important such as in narrow band measurements over sweeps of less than 5 MHz. An HP 8350B sweeper with HP 83500 series RF plug-ins covering the entire desired frequency range or with lesser spans can also be used in applications where a more economical source is sufficient. Both the HP 8340A and the HP 8350B include the necessary analog interface signals as well as full digital handshake compatibility with the main analyzer 101. This digital handshake compatibility allows the main analyzer 101 to act as the controller for the entire system by directly managing the source 109 to provide all of the inputs such as start frequency, stop frequency, centering, span, and modulation, as well as constraints that the source 109 normally places on itself internally. For example, if a user by means of the main analyzer 101 request the source 109 to sweep to an incompatible frequency such as 50 GHz, the source 109 will respond to the main analyzer 101 that such a frequency cannot be accommodated and the main analyzer 101 in turn informs the user of the situation. Therefore, the user need only be concerned with his interface to the main analyzer 101 and can use any source 109 that has implemented the required handshake protocols. Because the main analyzer 101 is in control of the source 109, it is also possible to automatically select a different frequency range or mode (stepped or swept) to be applied to each of the ports 1 and 2.

Integrated within each test set 107 is the first IF frequency converter 113 with three channels 113a, 113b, and 113c for reflection/transmission measurements and four channels 113a, 113b, 113c, and 113d for S-parameter measurements. RF to IF conversion is achieved through a sample technique equivalent to harmonic mixing. An harmonic of a tunable local oscillator 115 is produced by an harmonic generator 116 to mix with the incoming RF signal to provide the first IF signal at 20 MHz for the incident signal a1 on the input port 1, the incident signal a2 on the output port 2, the reflected or transmitted signal b1 on the input port 1, and the reflected or transmitted signal b2 on the output port 2. Frequency tuning for the local oscillator 115 is controlled by a phase lock loop 125 that compares the signal a1 or a2 in the reference channel first IF to an IF reference oscillator 119 in the IF/detector section 103. Any difference between the frequency of the signal a1 or a2 in the reference channel first IF and the IF reference oscillator 119 results in an error voltage on the error voltage signal line 121 via switch 123 that tunes the local oscillator 115 to the frequency that produces the desired first IF. Switch 123 is toggled to select the most appropriate signal a1 or a2 to lock on to based either on internal criteria within the system or as defined by the user. When using the internal criteria, if the incident signal port is port 1, a1 is selected by switch 123, and if the incident signal port is port 2, a2 is selected by switch 123. This scheme allows the local oscillator 115 to track the incoming RF when the RF frequency is changing with time as in the swept mode. The integrated test set 107 permits high RF to first IF conversion efficiency even at 26.5 GHz, making possible both high sensitivity and wide dynamic range measurements. The reflection/transmission test sets 107 require no internal switching since the fourth channel 113d is no required, and the S-parameter test sets 107 use only one electronic PIN diode switch located inside of the test set 107 such that it cannot contribute to uncertainties as it is switched prior to the ratio node of the power splitter.

Several concepts have been incorporated in the IF/detector section 103 of the main analyzer 101 to increase the precision of IF processing and signal detection. Most of the phase lock hardware 125 in the phase lock loop resides in this section 103. Harmonic mixing number and local oscillator pretuning are controlled digitally via lines 127 and 129 and offer phase lock and tracking performance that is precisely repeatable from sweep to sweep. Before the first IF signals proportional to a1, a2, b1, and b2 are sent to the synchronous detectors 131 and 133, they are down converted to a second IF at 100 KHz by mixers 138 and go through a pair of multiplexers 136 and variable gain amplifiers 134 in the second IF section 135. Amplifier gain is controlled and calibrated digitally and is varied by autoranging to optimize the second IF signal levels 130 and 132 available to the synchronous detectors 131 and 133 resulting in an order of magnitude improvement in signal to noise performance and dynamic accuracy for the detector output signals x1, y1, x2, and y2. Likewise, the synchronous detectors 131 and 133 employ a digital architecture that allows for precise control of their 90 degree phase shift function which results in improved accuracy as well as common mode rejection of local oscillator phase noise effects. Finally, the detected signals x1, y1, x2, and y2 are multiplexed with a sample-and-hold/multiplexer (MUX) 137 and then digitized by an analog-to-digital converter (ADC) 139 with 19 bits of resolution. Each ADC conversion takes approximately 40 microseconds, and four readings are made for each RF frequency data point to provide the real and imaginary data for both the reference signal 130 and test signal 132.

The output of the ADC 139 is then passed on a 16 bit bus 141 to a high speed central processor (CPU) 143 which includes a microprocessor such as a Motorola 68000 as well as the associated microprocessor system interrupt and I/O control circuitry. Because the CPU 143 is integrated into the main network analyzer 101 it is possible to utilize a multi-tasking architecture to make more efficient use of time than has previously been possible. This architectural integration also permits substantial increases in data processing flexibility and system control performance. Via a dedicated system interface and bus 145, the CPU 143 control the RF source 109, the test set 107, and, along with the sample selection and timing circuitry 146, all of the IF processing functions including the phase lock hardware 125, autoranging in the IF amplifiers 134, detection by the synchronous detectors 131 and 133, and digitization by the ADC 139. The CPU periodically initiates a self calibration sequence for the IF amplifiers 134, synchronous detectors 131 and 133, and the ADC 139 and the resulting gain, offset, and circuitry changes are stored in memory 147, so that the changes in the IF amplifiers 134 can be subtracted from measured results. The CPU 143 also performs all data processing functions for the system. The signals in the IF section 103 are detected as linear real and imaginary components of a vector quantity, and the CPU 143 processes the detected data into a variety of formats for presentation on the CRT display 149. By digitally computing the various measurement formats, improvements in dynamic range and meaningful resolution are gained over traditional analog circuit processing techniques.

With the known network analyzer system, an external computer was required in order to characterize and remove systematic errors. With the present RF vector network analyzer, this capability exists internally with enough storage capacity (i.e., 256K bytes of random access memory (RAM) and 256K bytes of bubble memory) in the memory 147 to retain up to two 401 point 12-term error corrected traces of data. (Note: each byte of memory consists of eight bits of data storage.) In addition, the measured data can be converted to show the response of the DUT 111 as a function of time (time domain) using an internal Fourier transform process. All data processing takes place virtually in real time by means of parallel data processing in the CPU 143 aided by the incorporation of a dedicated, floating point, complex number, vector math processor 151 designed specifically for fast vector computations. The multiplication of two complex numbers by the vector math processor 151 requires only one operation with the product available within 20 microseconds, so that error corrected measurements results are available 1000 times faster than in the prior art. By means of an internal vector graphics generator 153, the real time processed data is then immediately presentd on the CRT 149, on a digital printer/plotter 155, or via an IEEE-488 (HP-IB) interface and bus 157 to external devices. Present as well as past states of front panel controls 159, past and present traces of data, and entire system calibrations can also be stored in and recalled from the memory 147 or loaded and read from a built-in tape drive 161 by means of the system interface and bus 157 under control of the CPU 143.

The vector math processor 151 is constructed from a series of commercially available medium scale integrated circuits.

Description of the Test Sets

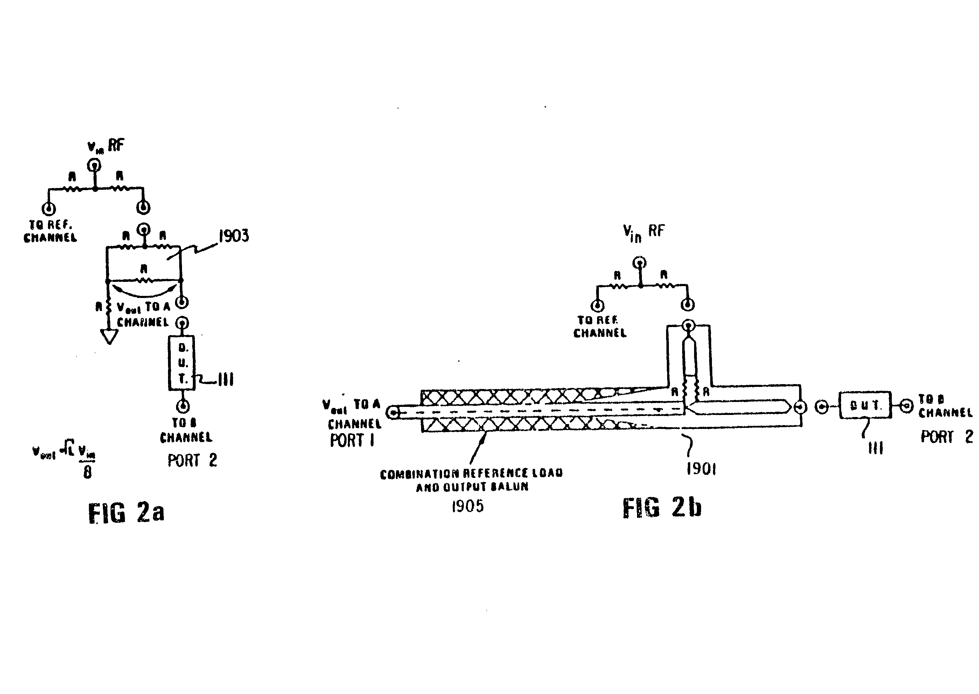

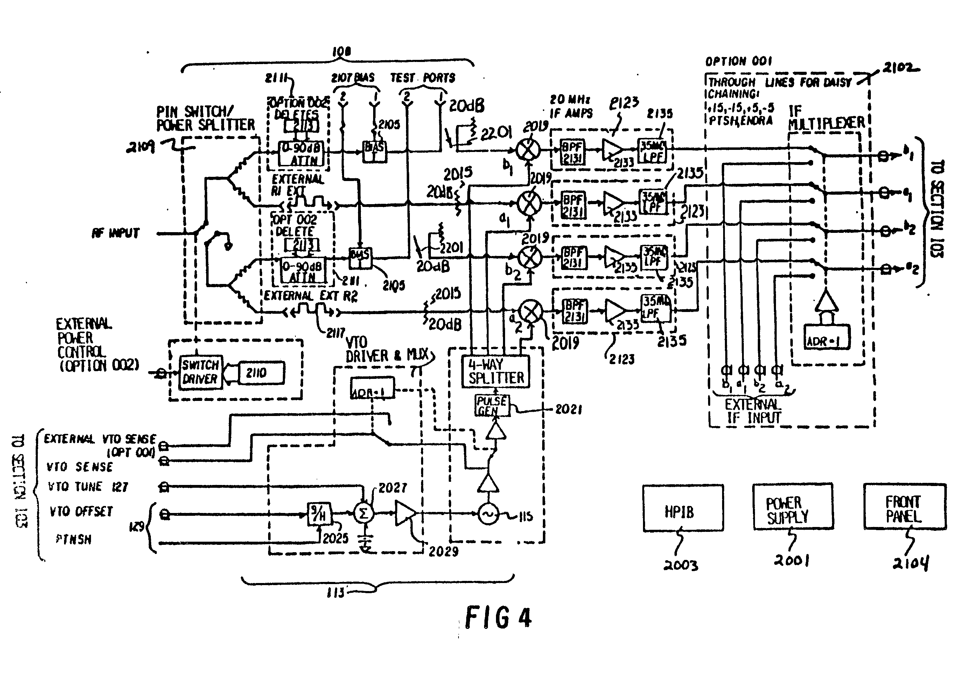

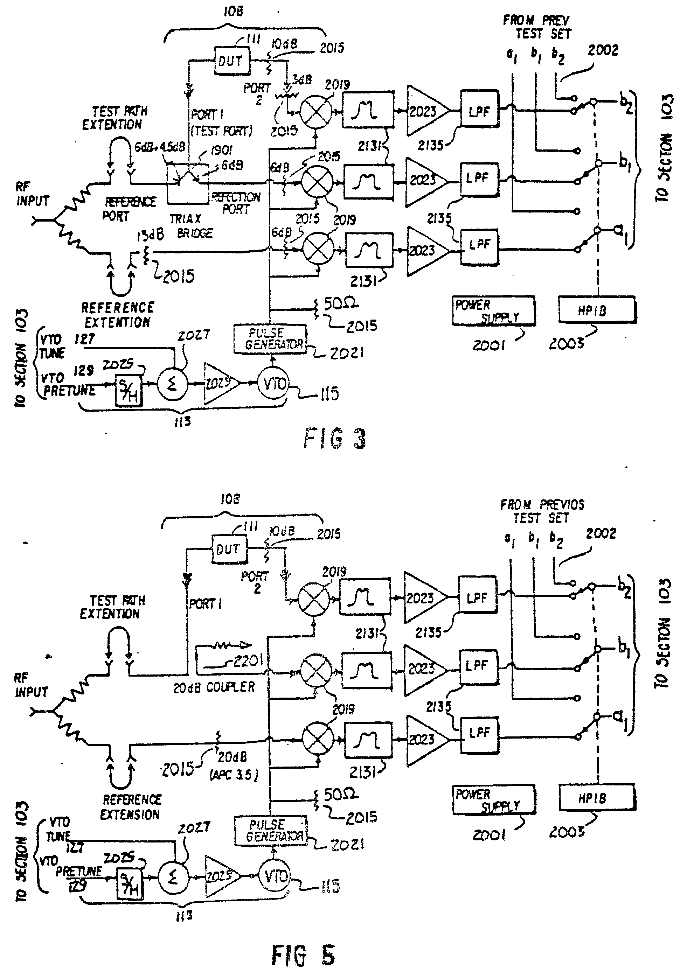

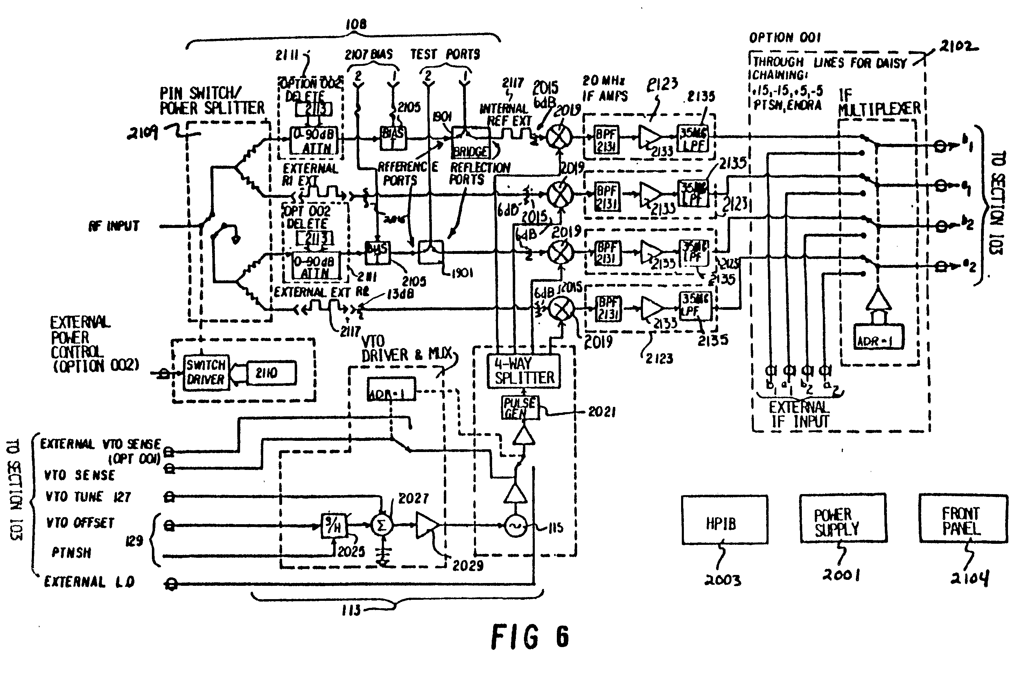

The wideband test sets 107 to 26.5 GHz include a high performance RF triaxial directional bridge 1901 as described in European Patent Application entitled "Broadband Radio Frequency Directional Bridge And Reference Load", Serial No. 8411631.9, filed December 1, 1984, and shown in figures 2a and 2b, coupled to each of the DUT ports 1 and 2 as shown in figures 3 and 4. The directional bridge 1901 is a balanced Wheatstone bridge 1903 that extracts a floating vector signal for measurement in a single-ended detector system without disturbing the balanced configuration. Included in this high performance RF directional bridge 1901 is a combination reference load and balun 1905 which provides signal separation over the entire frequency range from 45 MHz to 26.5GHz, and also permits the application of a DC bias as part the RF input $V_{in}$ to the DUT 111 via a conventional RF bias tee 2105. In contrast, the narrower band test sets 107 as shown in figures 5 and 6 utilize a conventional directional coupler 2201 for each port to cover the frequency range of 0.5 to 18 GHz. By incorporating the signal separation devices 108 in the test sets 107, broadband vector measurements are made possible with just one connection of the DUT 111 between port 1 and port 2.

Each of the test sets 107 contains its own built in power supplies 2001, to simplify various system configurations and each of the test sets 107 has its own HP-IB interface 2003, coupled to the system bus 145 in order to provide control and identification to the main analyzer 101. Each of the test sets 107 is connected respectively to section 103 via a first IF multiplexer 2002 or 2102 to provide daisy chaining of several test sets. The first IF multiplexer 2002 and 2102 are in turn connected respectively to the a1, b1, and b2 connections for the reflections/transmission test sets in figures 3 and 5, and the a1, a2, b1, and b2 connections for the S-parameter test sets in figures 4 and 6. The S-parameter test sets also include: front panel indicators 2104 to signal the active test port, a conventional bias tee 2105 on each of the test channels to provide voltage bias 2107 needed in the testing of active devices, PIN diode transfer switches 2109 under control of the main analyzer 101 via the system bus 145 and a switch interface 2110 for switching the RF input between the ports 1 and 2, and variable attenuators 2111 under control of the main analyzer 101 via the system bus 145 and an attenuator interface 2113. Various RF pads 2015 and test and reference extentions 2117 are provided to adjust and balance the RF power levels.

Each of the test sets has a frequency converter 113 to provide the first IF conversion of the RF signals in immediate proximity to the RF input and the test ports. Within the frequency converters 113 are the VTOs 115, the first IF samplers 2019, pulse generators 2021 to drive the first IF samplers 2019, and first IF amplifiers 2023 and 2123. The first IF amplifiers 2123 also include an input band pass filter 2131, a filter amplifier 2133, and an output low pass filter 2135 to provide additional signal shaping. Each of the VTOs 115 is driven by a sample/hold circuit 2025, a summing node 2027, and a buffer amplifier 2029 coupled to the phase lock circuitry 125 in section 103.

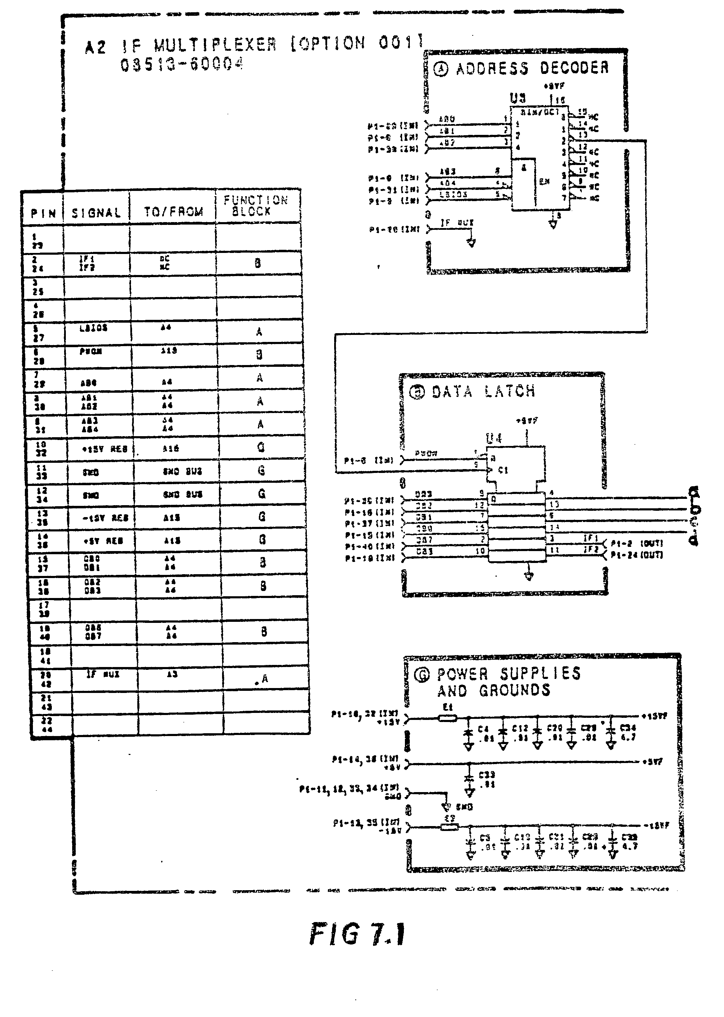

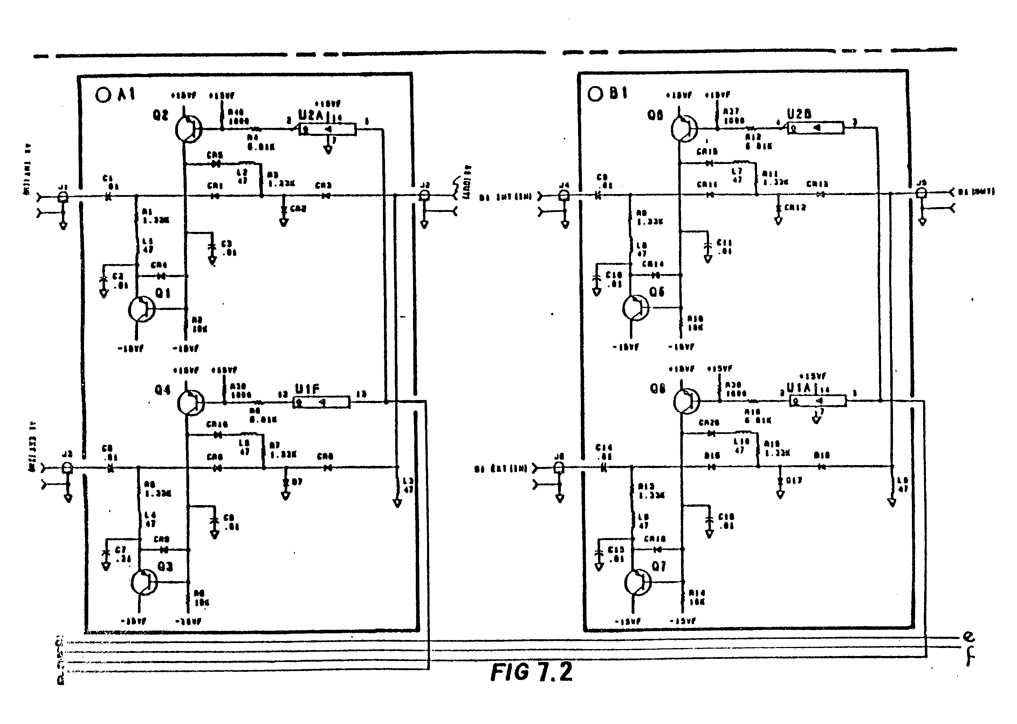

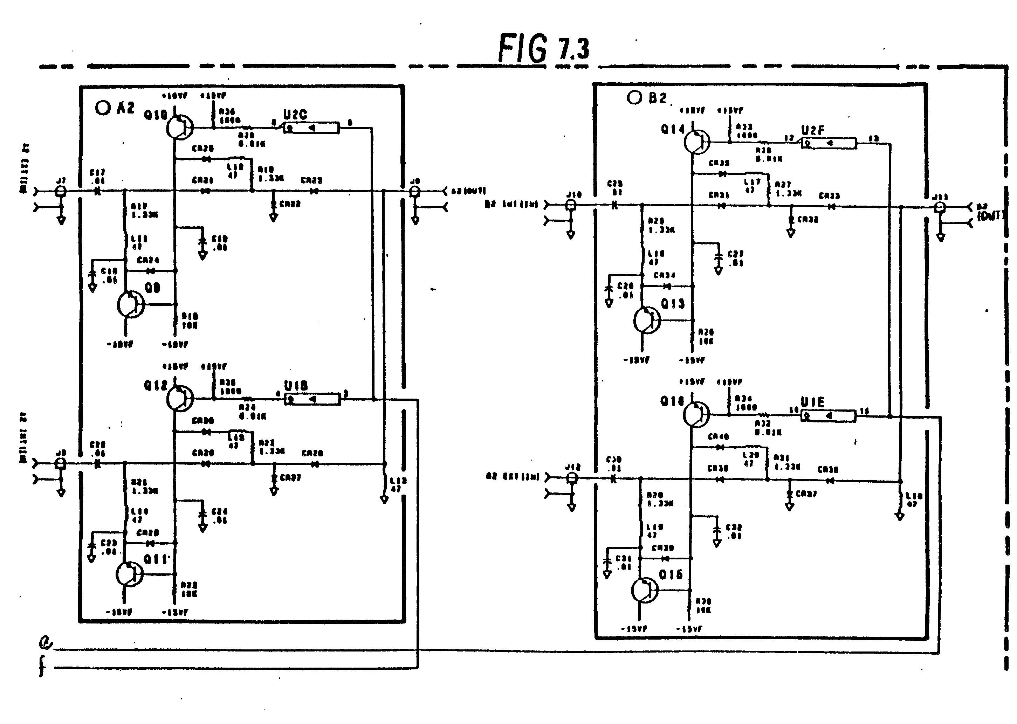

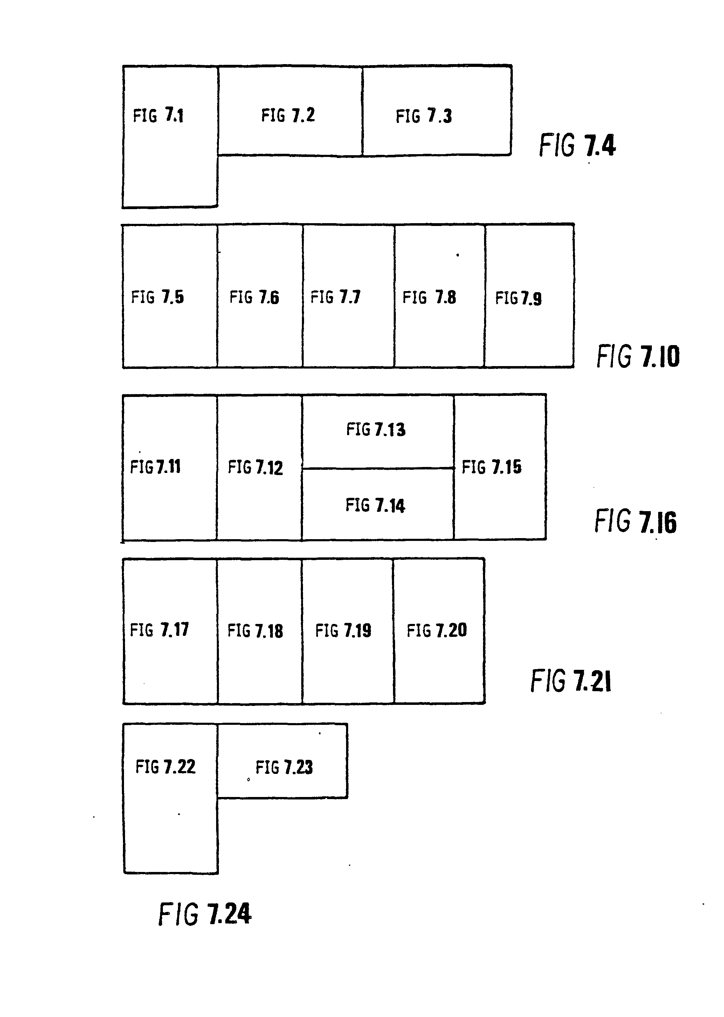

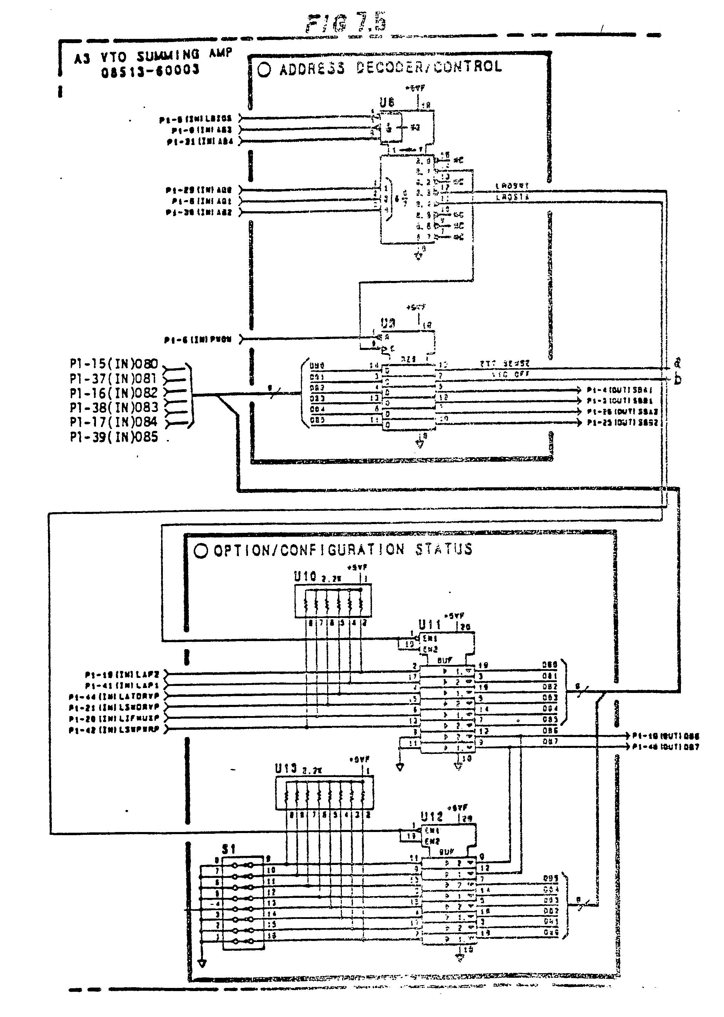

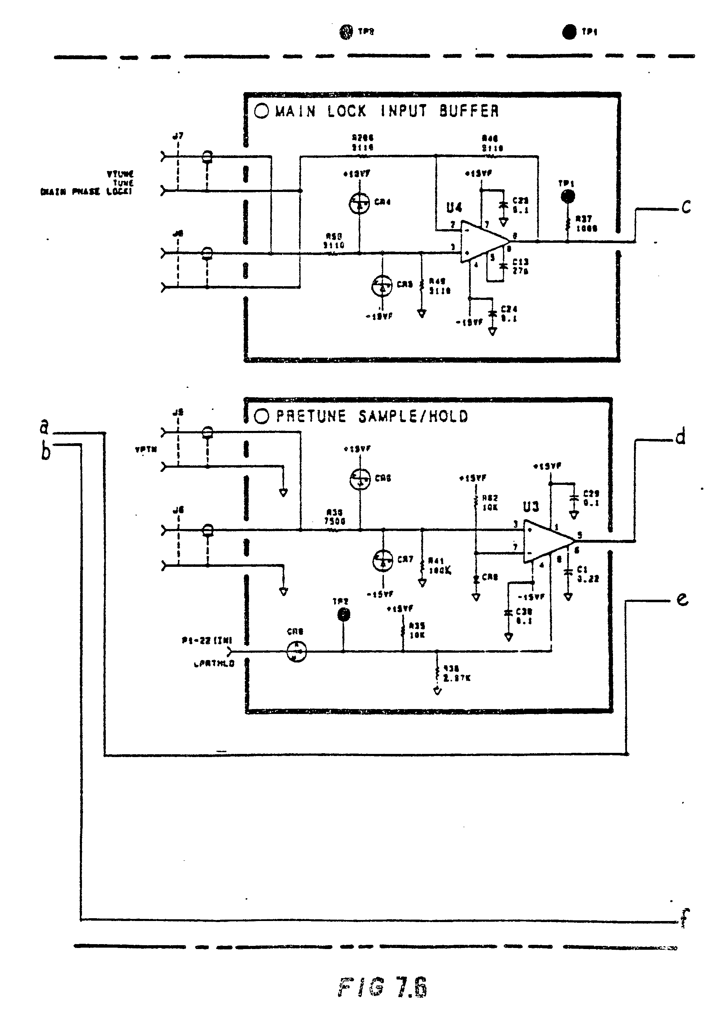

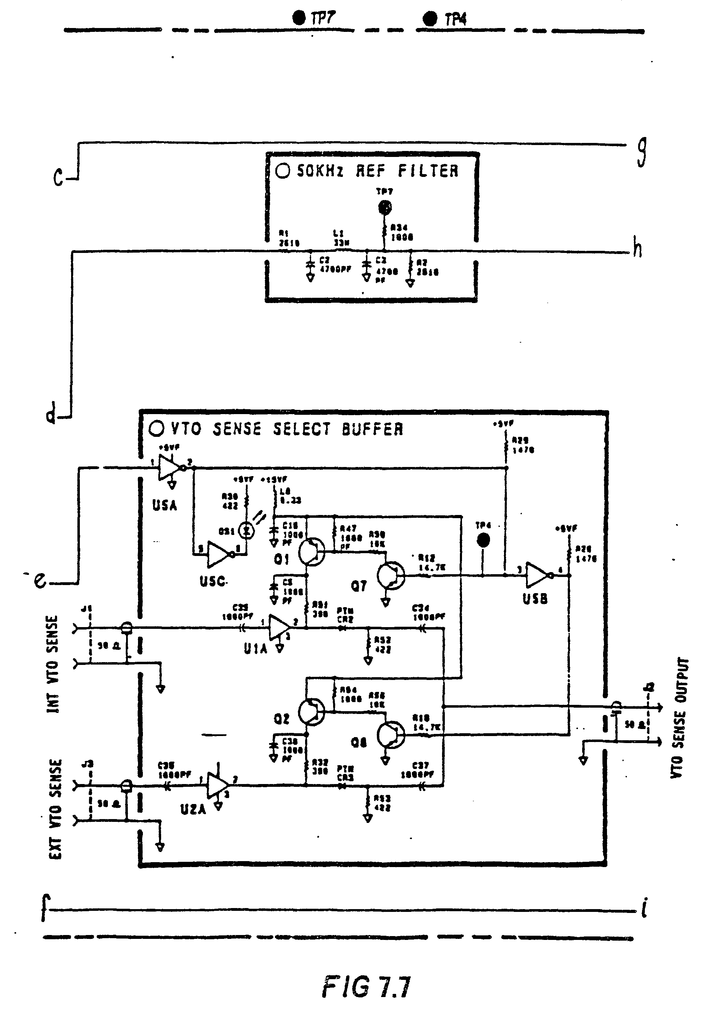

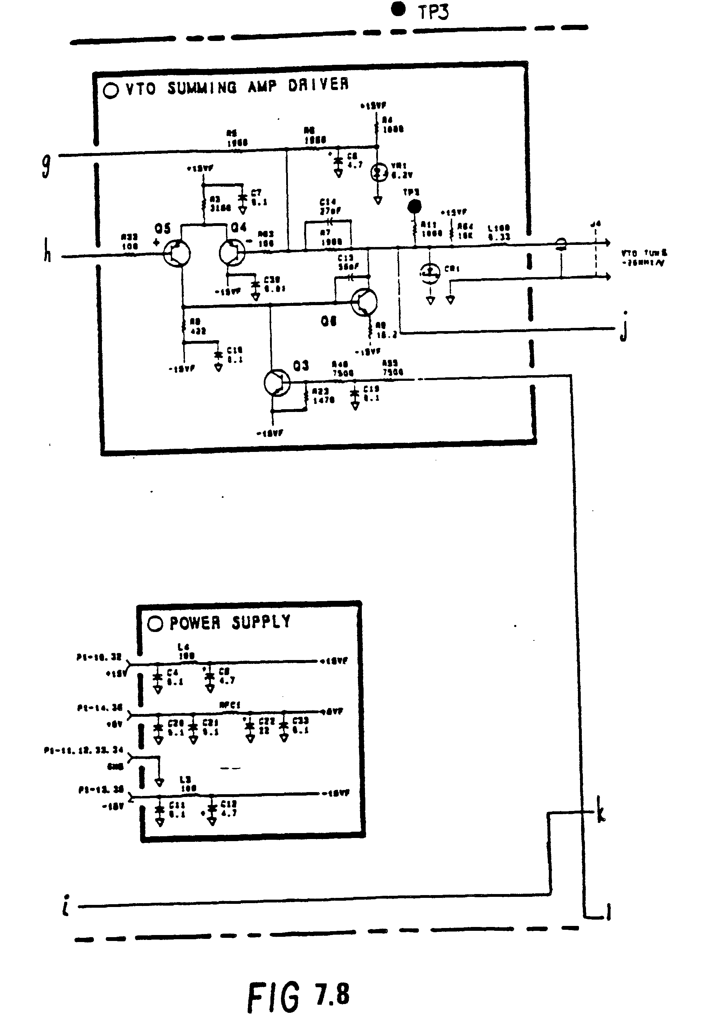

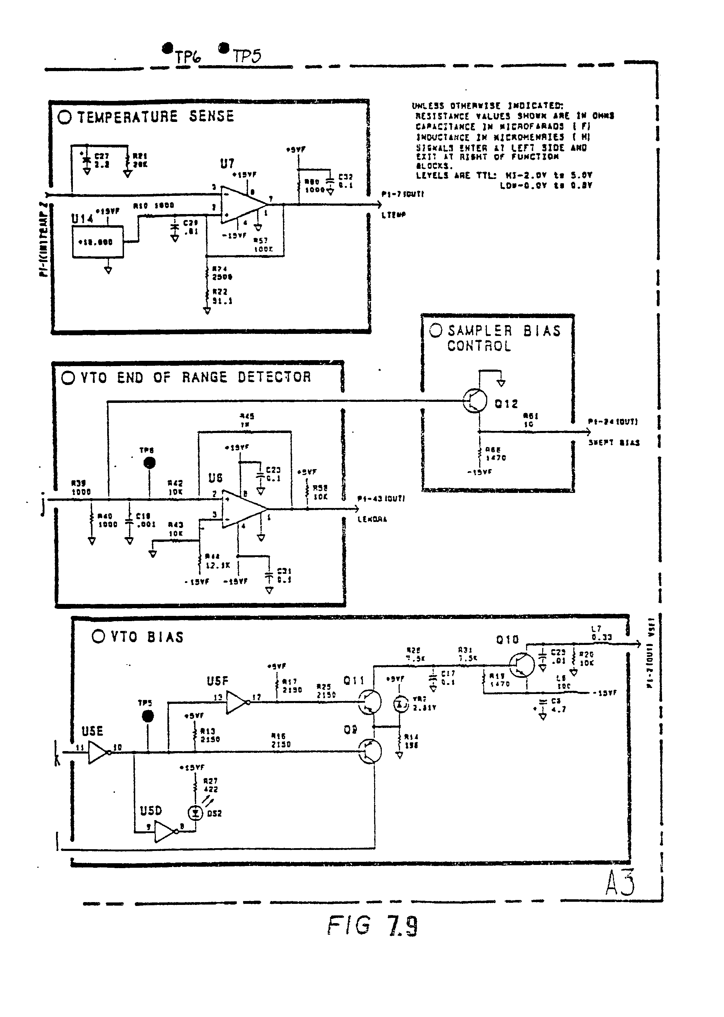

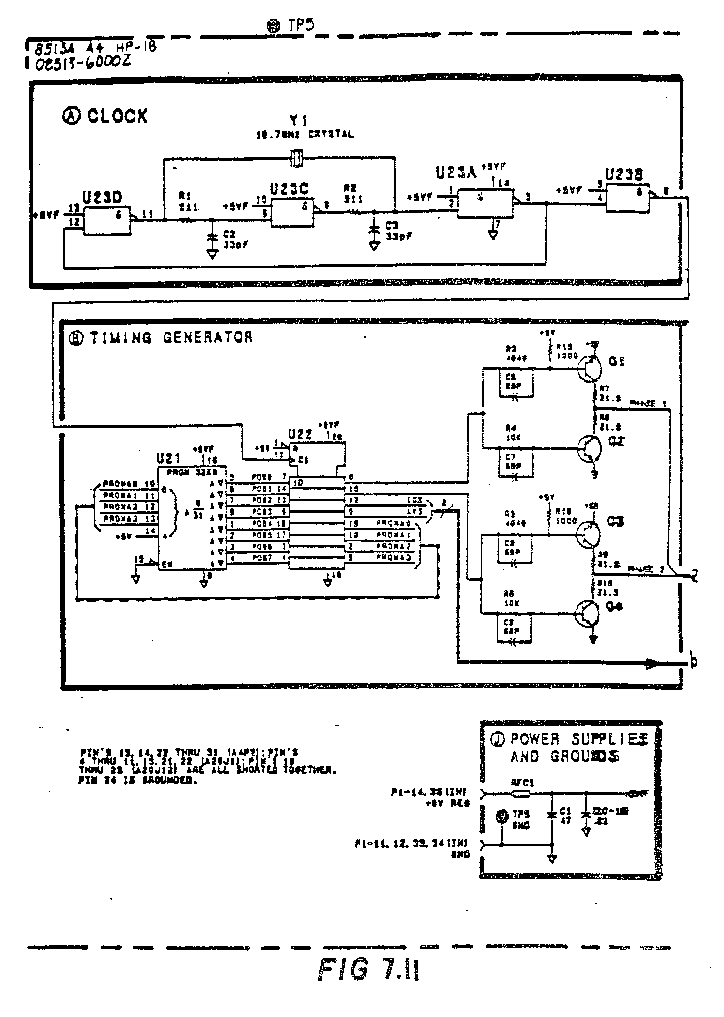

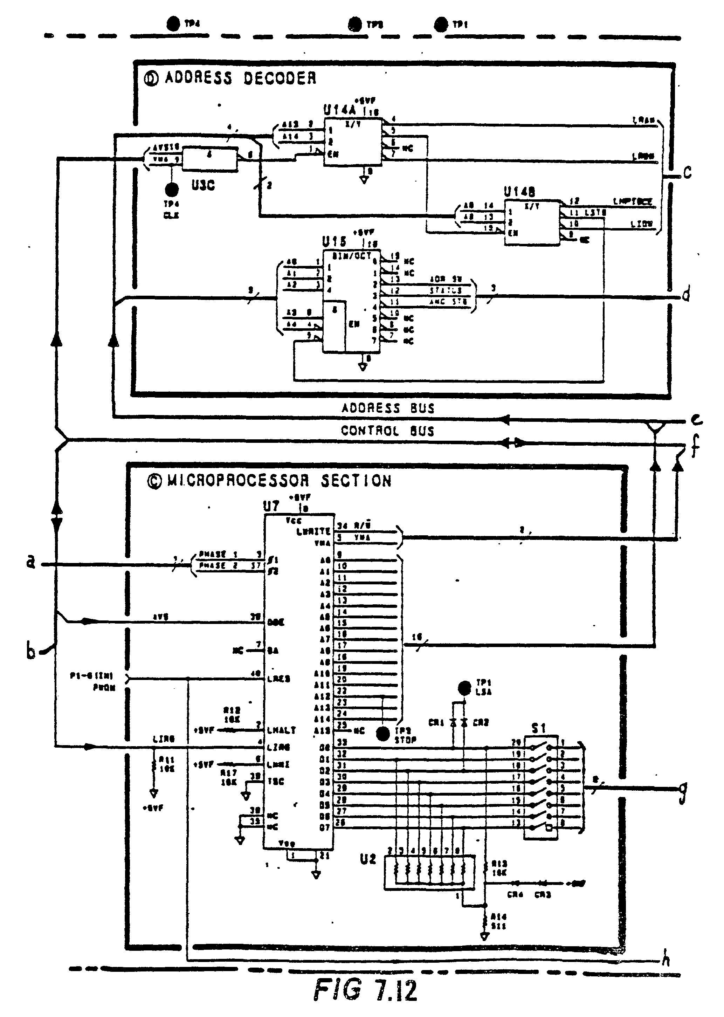

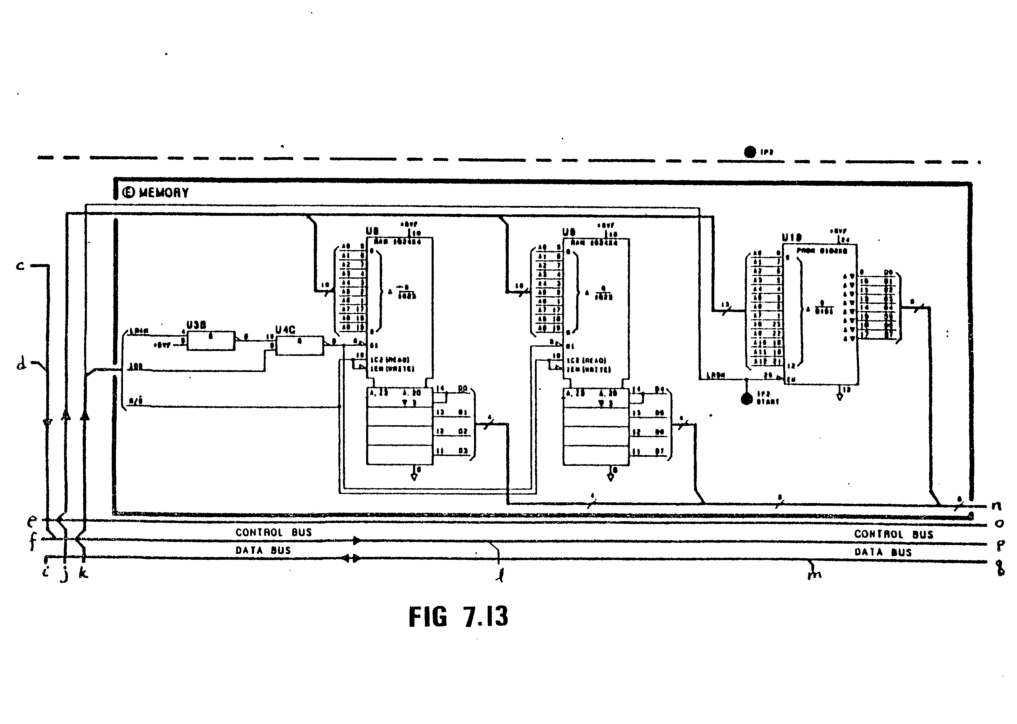

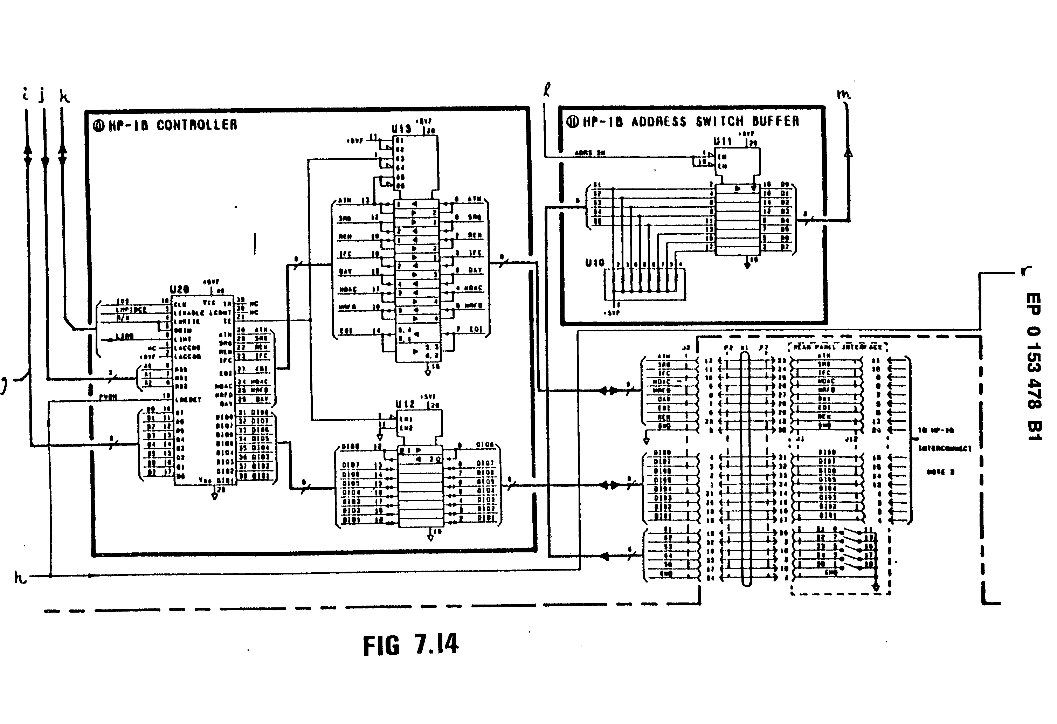

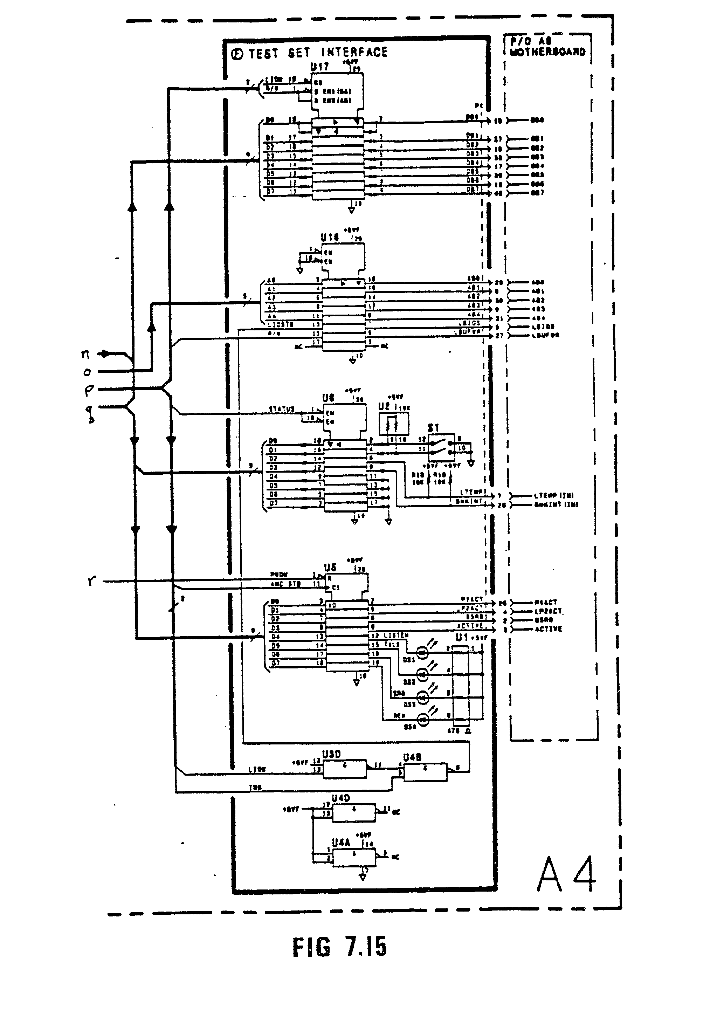

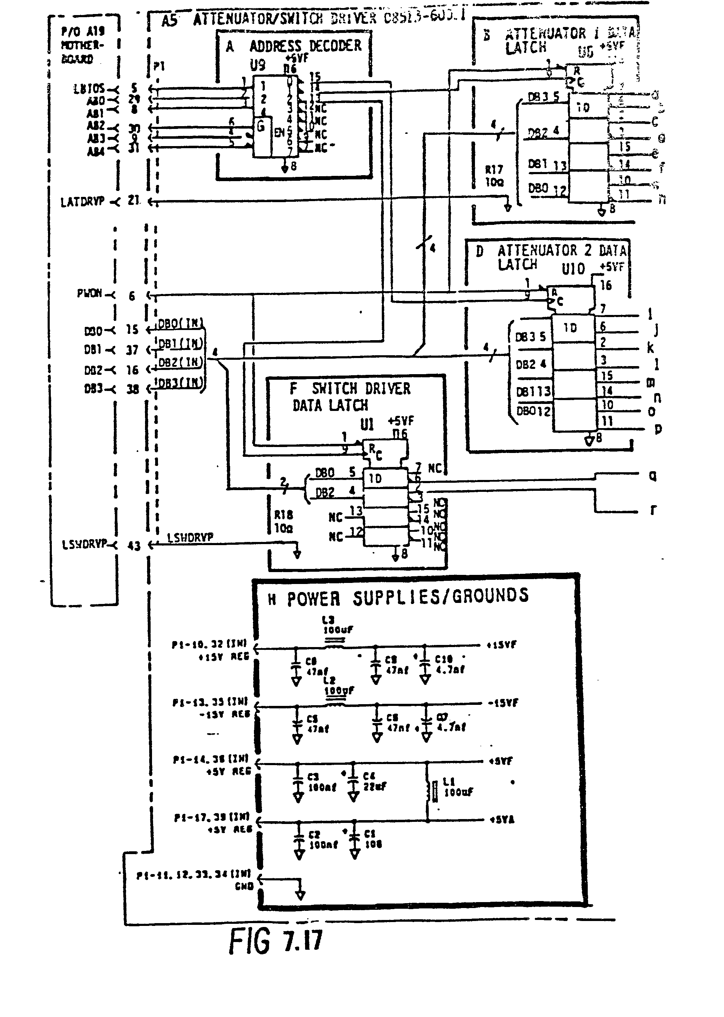

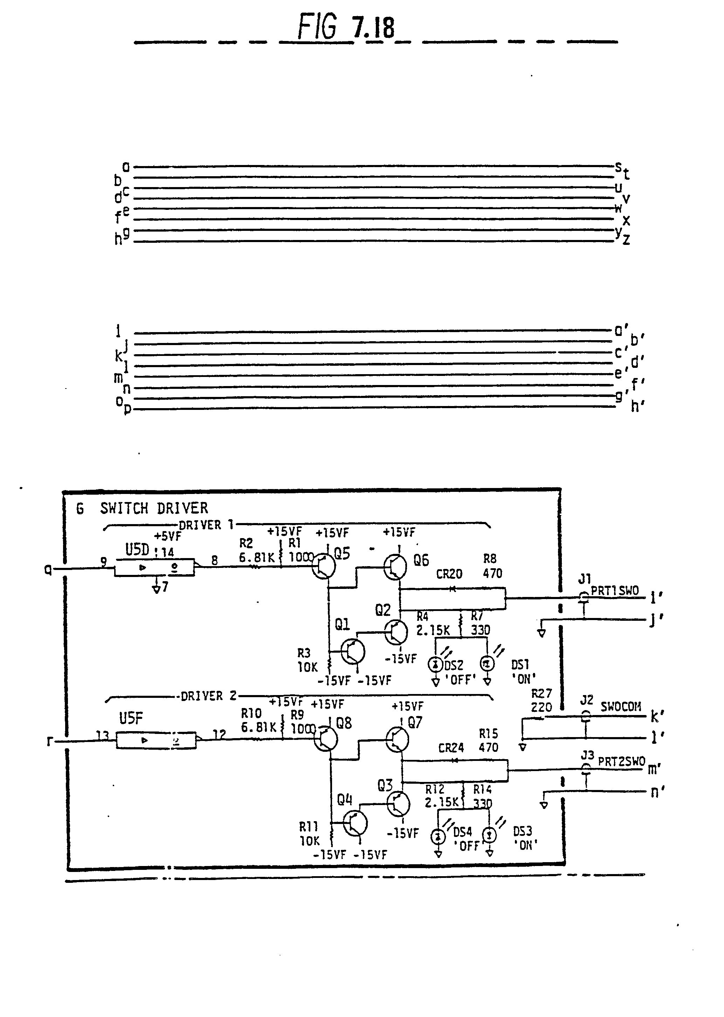

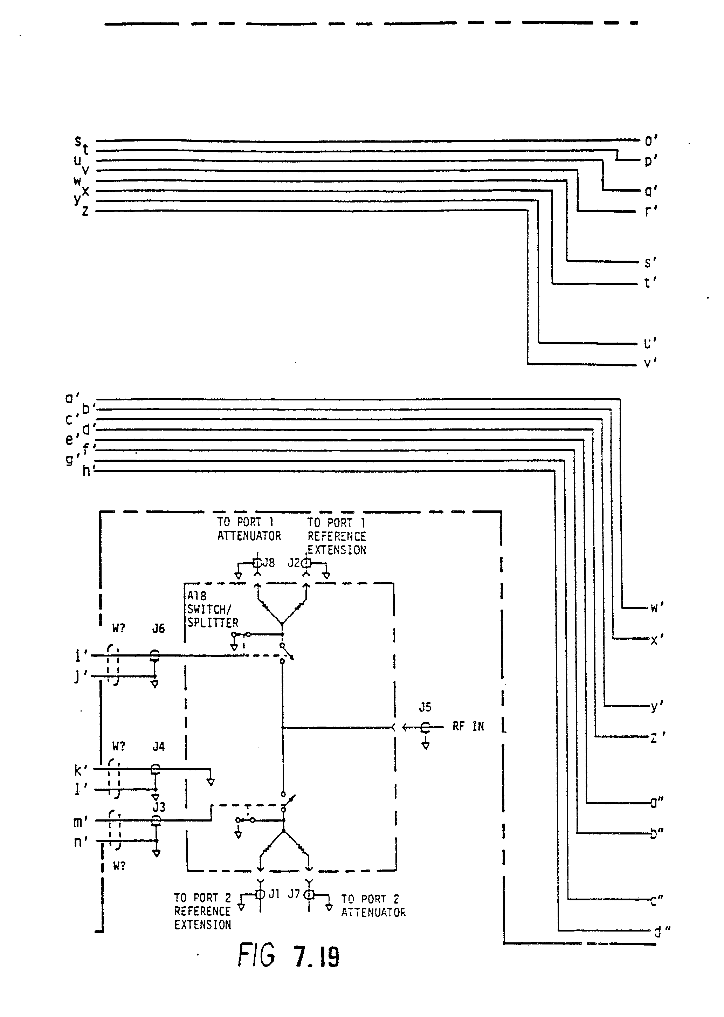

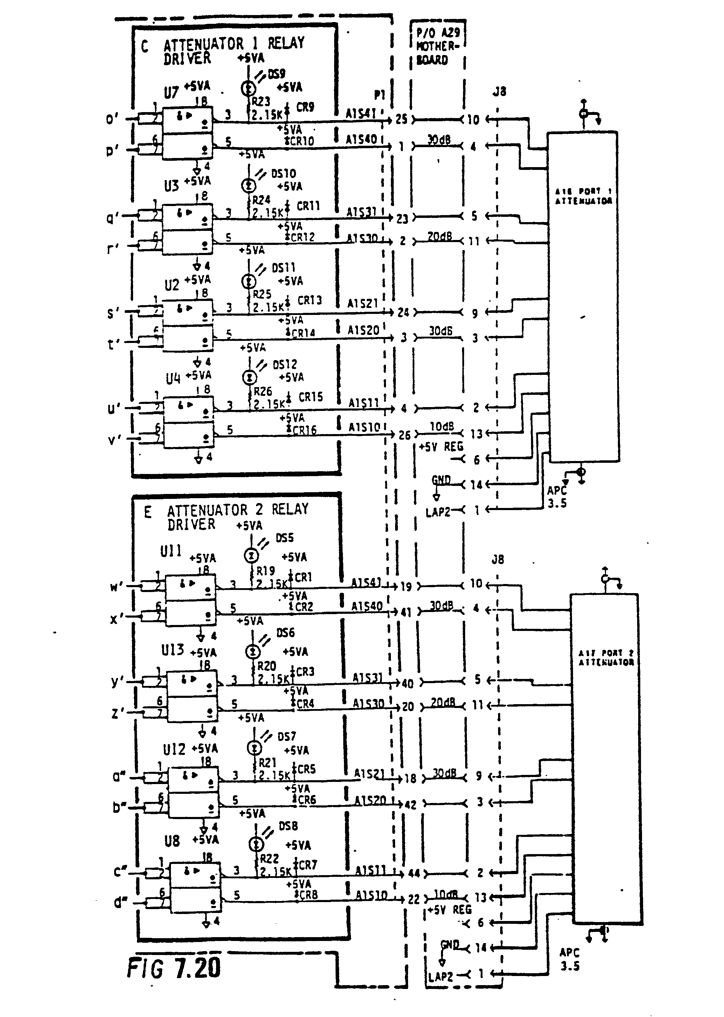

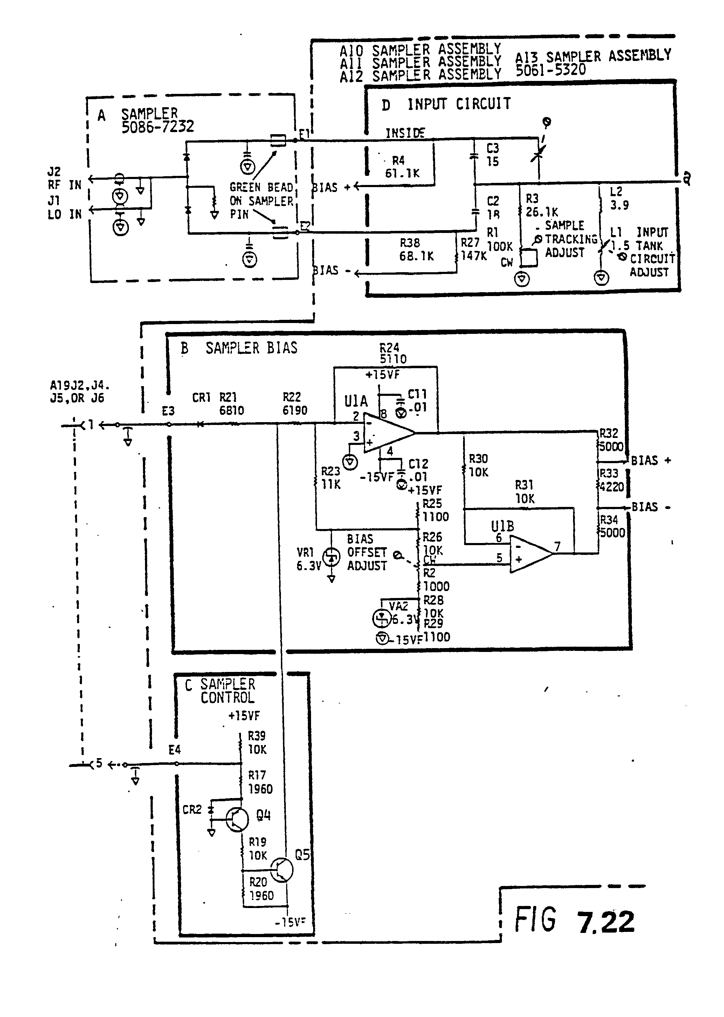

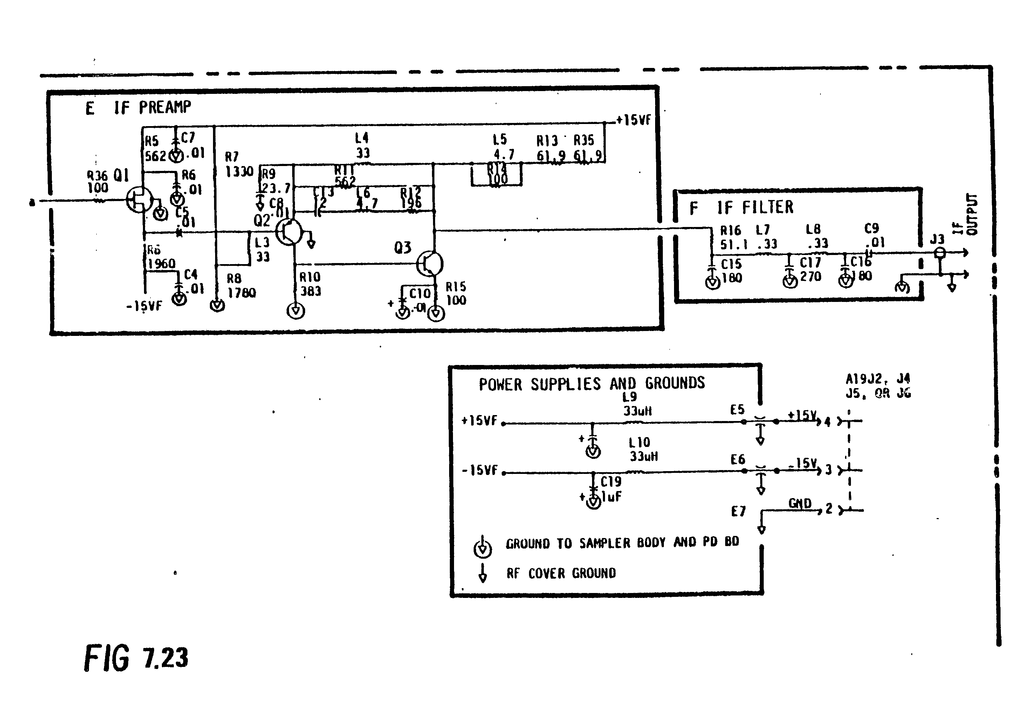

Figures 7.1 through 7.24 show detailed schematics for selected parts of the circuitry associated with the test sets 107 as shown in figures 3 through 6. Figures 7.1 through 7.4 show the first IF multiplexers 2002 and 2102, figures 7.5 through 7.10 show the VTO 115 and related drivers, figures 7.11 through 7.16 show the HP-IB interface 2003, figures 7.17 through 7.21 show the attenuators 2111 and the PIN diode switch 2109, and figures 7.22 through 7.24 show the first IF samplers 2019 and the first IF amplifiers 2023 and 2123.

Second IF

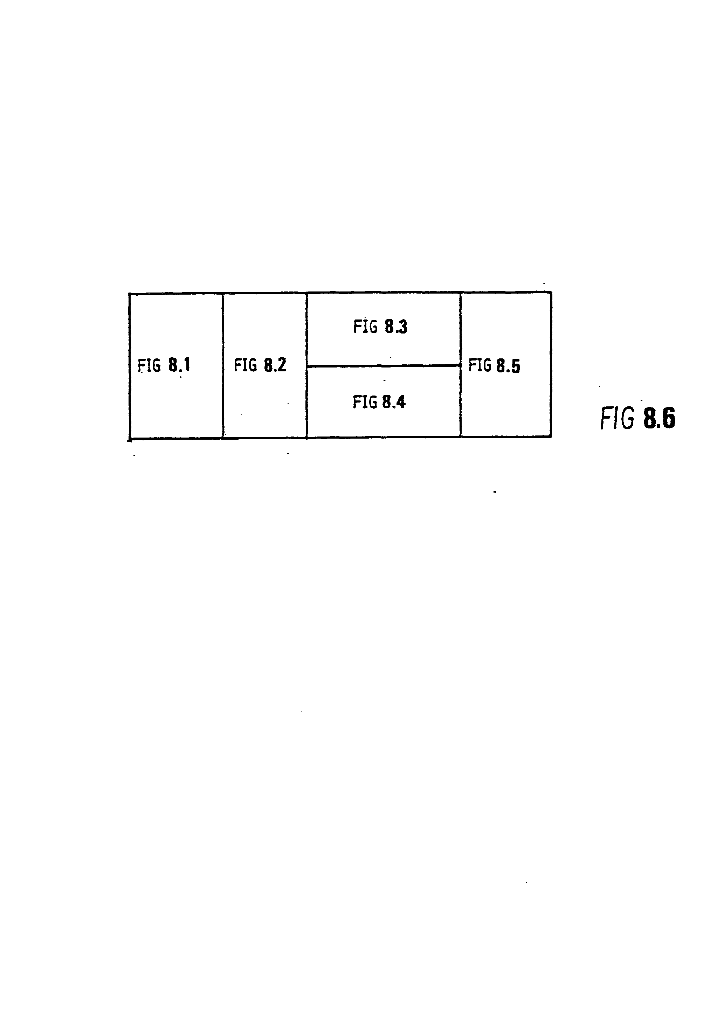

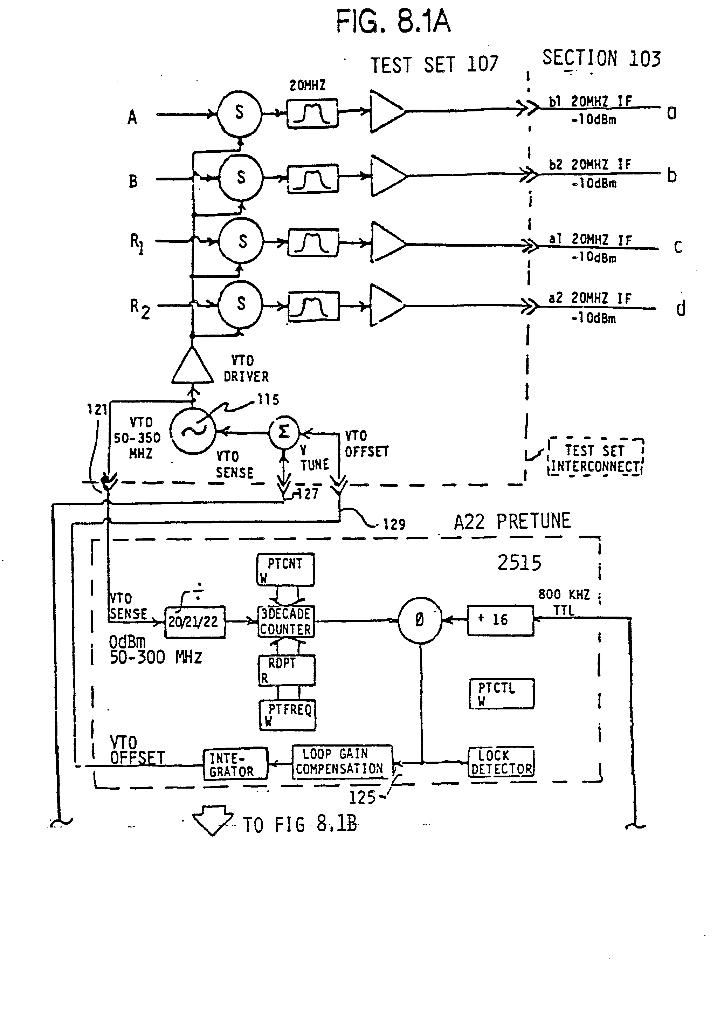

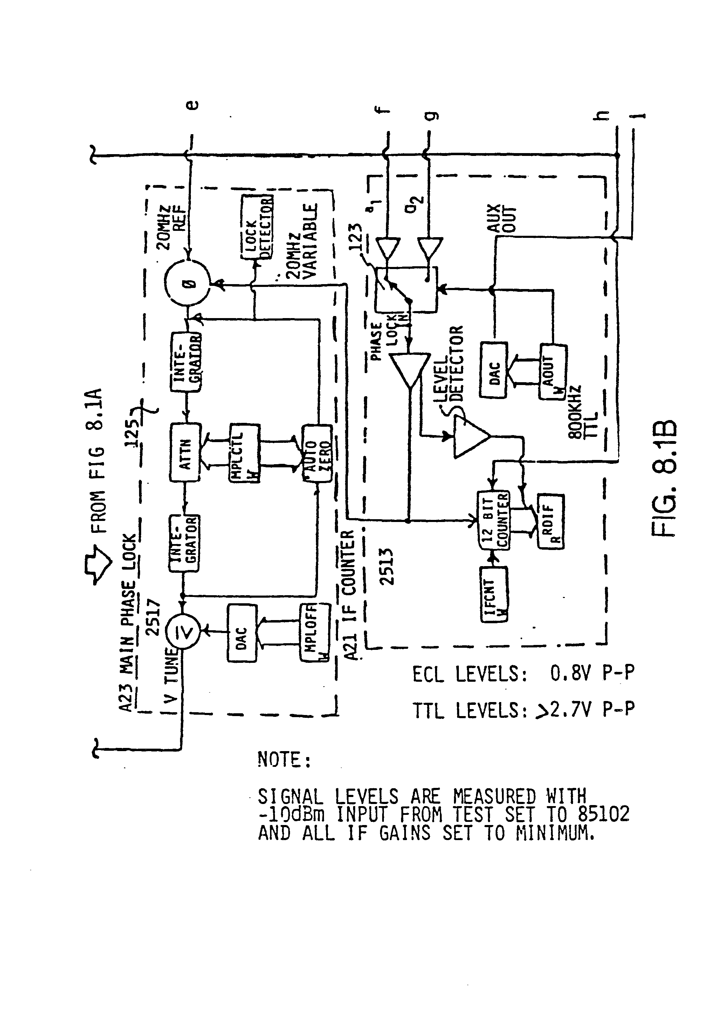

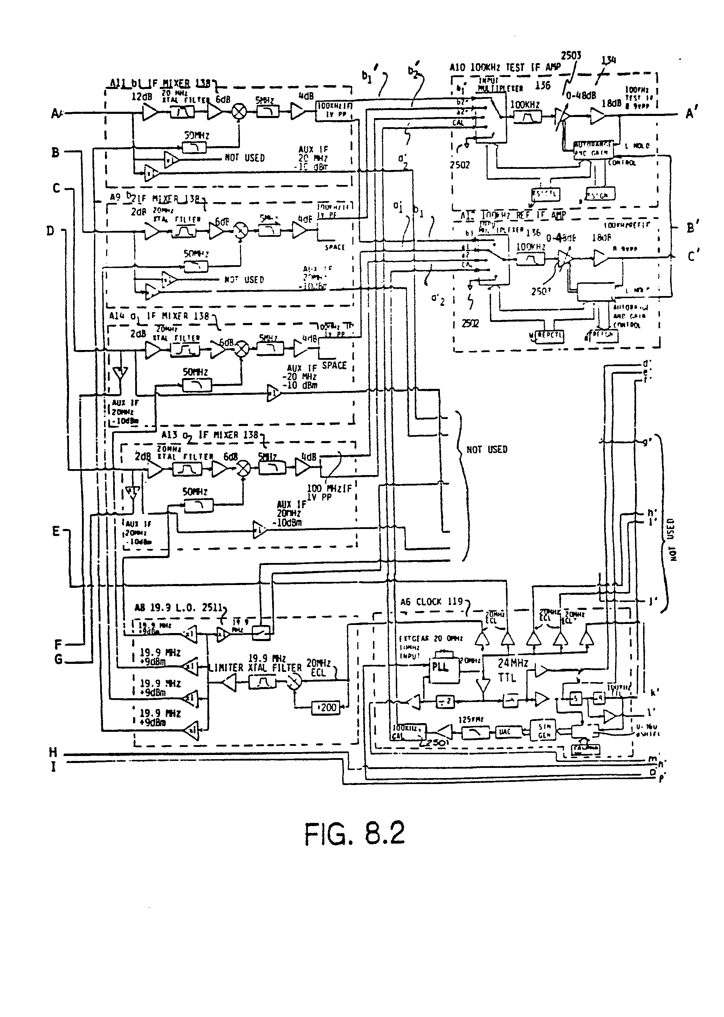

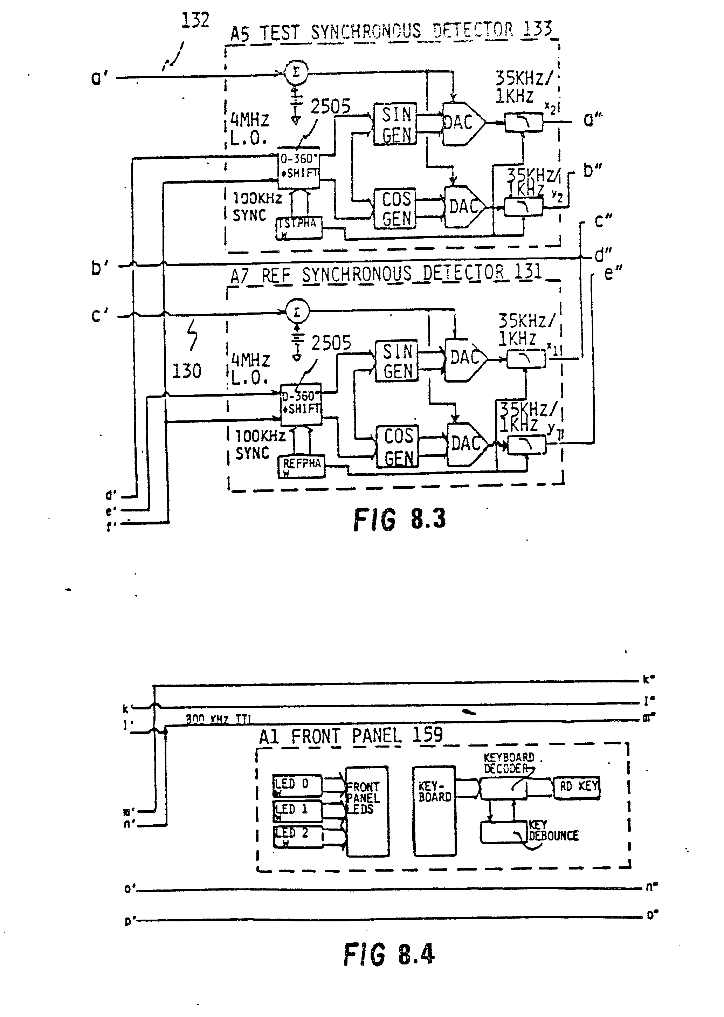

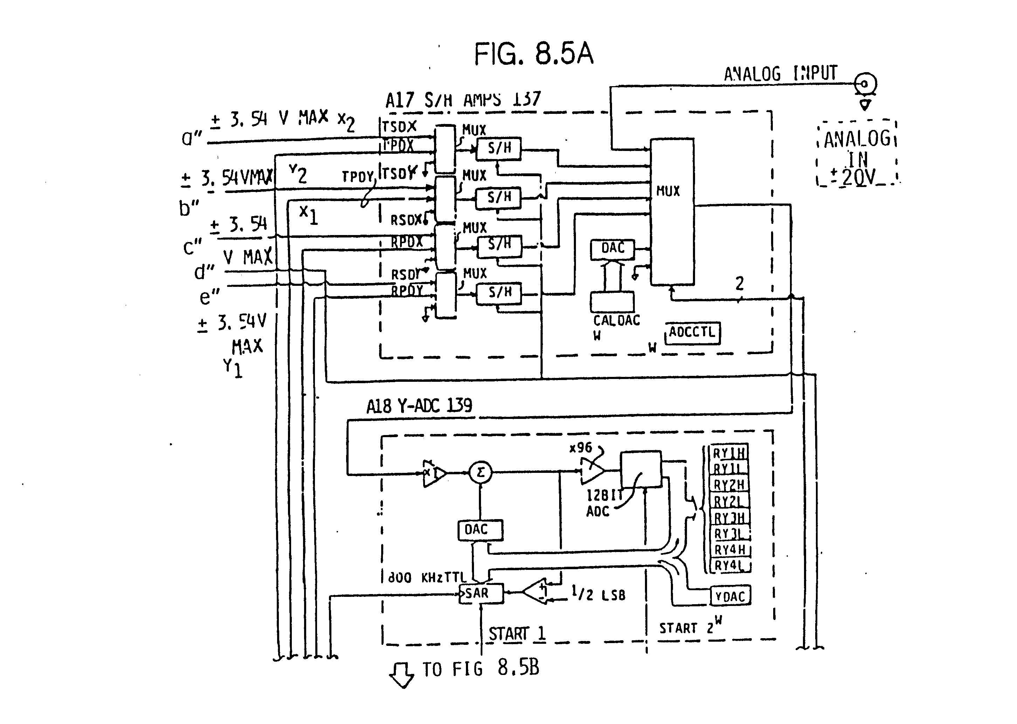

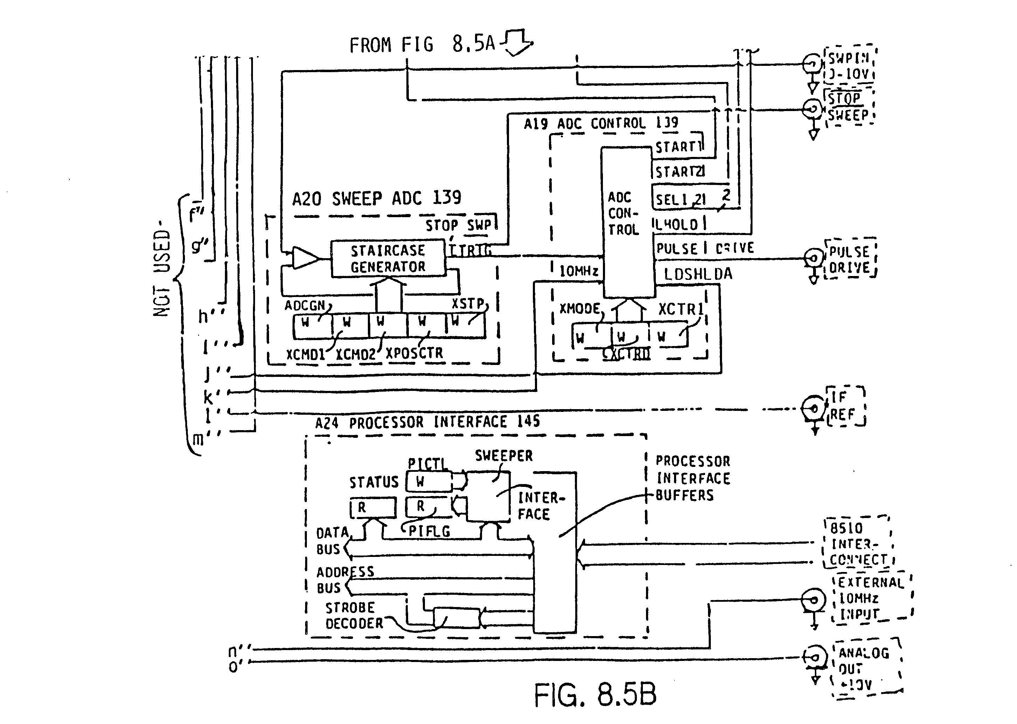

A detailed block diagram of the second IF/detector section 103 as shown in figure 1 is illustrated in figures 8.1 through 8.6. After the signals $a_1$, $a_2$, $b_1$, and $b_2$ have been converted to the second IF frequency by the second IF mixers 138, the resulting signals $a_1'$, $a_2'$, $b_1'$, and $b_2'$ are sent to the second IF MUXs 136 as shown in figure 8.2 A 100 KHz calibration frequency 2501 produced by clock 119 and a ground input 2502 are also sent to the second IF MUXs 136 so that the second IF channels can be automatically calibrated for both gain and offset errors. This automatic calibration is performed by individually measuring the vector gains of the four cascaded 12dB amplifiers that make up the amplifiers 2503 each to within 0.001 dB with the help of the ADC 139. Offset errors are removed by applying the ground input 2502 to the MUXs 136, turning off all gain in the amplifiers 2503, and measuring the resulting signal with the ADC 139 for each of four phase offsets (i.e., 0, 90, 180, and 270 degrees) of the synchronous detectors 131 and 133, thus rotating the measurement plane used in the synchronous detectors 131 and 133. This change in phase offset and rotation of the measurement plane in the synchronous detectors 131 and 133 is accomplished by adjusting the phase angle of the demodulating signal used for synchronous detection by means of the adjustable phase shifters 2505 as shown in figure 8.3.

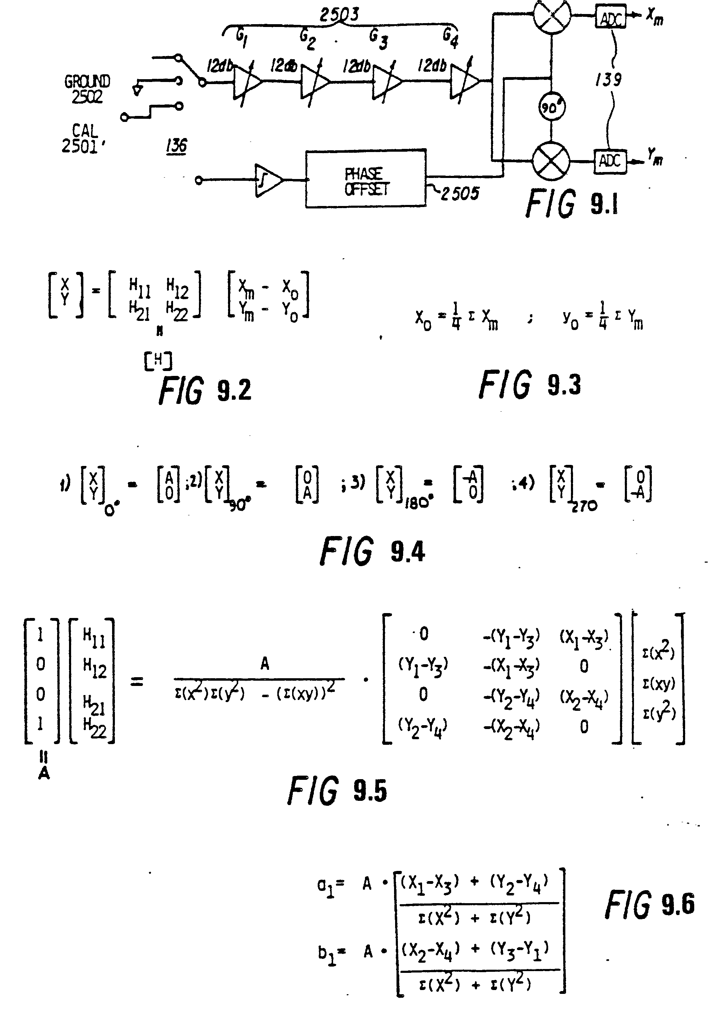

As shown in figures 9.1 through 9.6 it can be seen that the true values of X and Y can be determined from the measured values of $X_m$ and $Y_m$ from the equation shown in figure 9.2. First, the offsets $X_0$ and $Y_0$ are determined by grounding the input of MUX 136 as shown in figure 9.1, turning off all gains $G_1$, $G_2$, $G_3$, and $G_4$, and measuring $X_m$ and $Y_m$ for each of four phase offsets 0, 90, 180, and 270 degrees. $X_0$ and $Y_0$ are then calculated by the relationship shown in figure 9.3. H is determined by selecting the calibration signal 2501 and turning on the gain $G_4$. $X_m$ and $Y_m$ are then measured for each of the four phase offsets and the offsets $X_0$ and $Y_0$ are subtracted. H can then be calculated using the four quadrature relationships shown in figure 9.4 and performing a least squares error fit to each of the four measured data points as shown in figure 9.5, where A is the level of the calibration signal 2501, the X and Y terms correspond to $X_m$—$X_0$ and $Y_m$—$Y_0$, and Sigma is the summation of the four quadrature measurements. Determining the gain and phase of the four amplifiers $G_1$ through $G_4$ requires that each be independent of one another since $H = G_1 * G_2 * G_3 * G_4$. First with only $G_1$ on, $X_m$ and $Y_m$ are measured for each of the four phase offsets and a corrected X' and Y' are calculated using the correction coefficients previously determined during the offset correction. Using the equations shown in figure 9.6 the complex gain (a + jb) can be calculated that will best translate the four X' and Y' data points into the quadrature relationships shown in figure 9.4. The measurement of $X_m$ and $Y_m$ and calculation of $a_1$ and $b_1$ as above is repeated sequentially with each of the amplifiers $G_2$, $G_3$, and $G_4$ on one at a time.

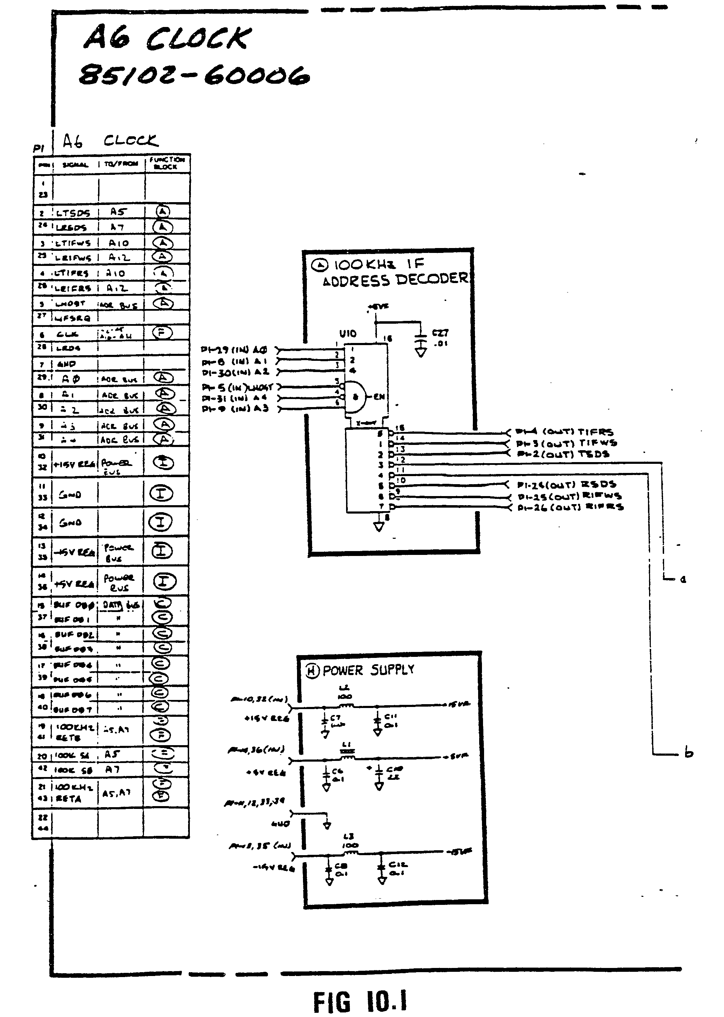

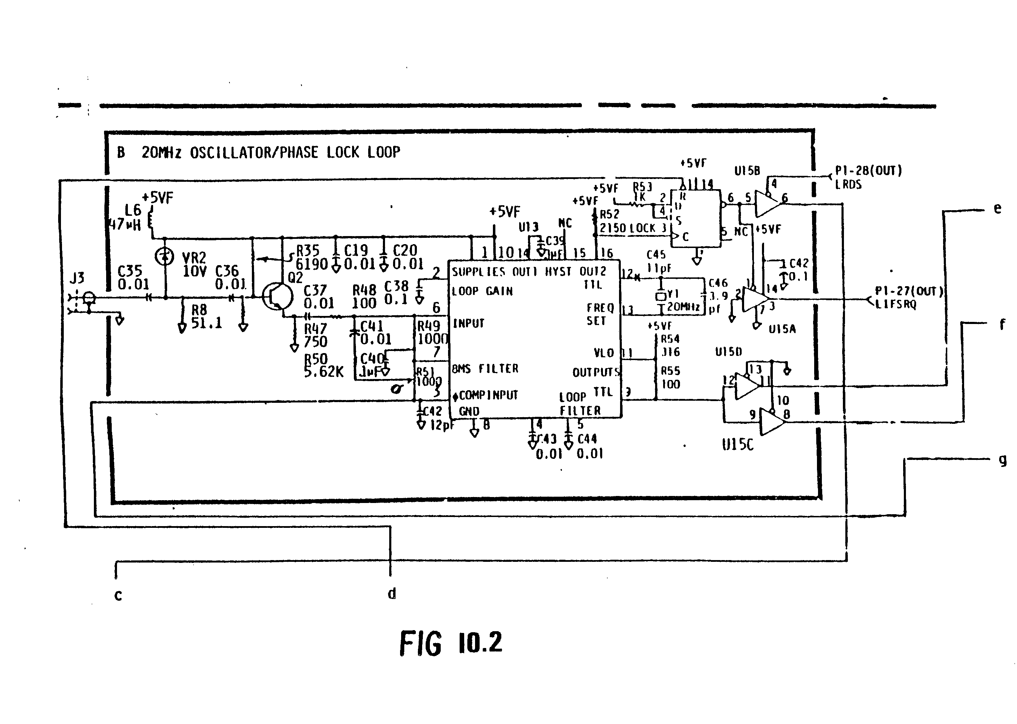

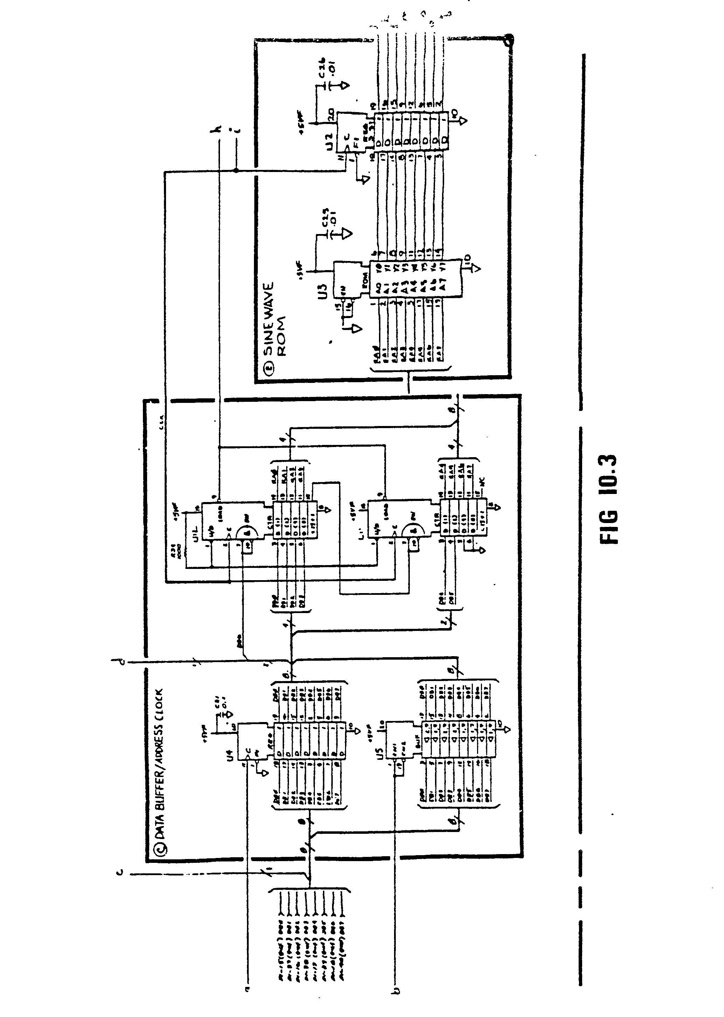

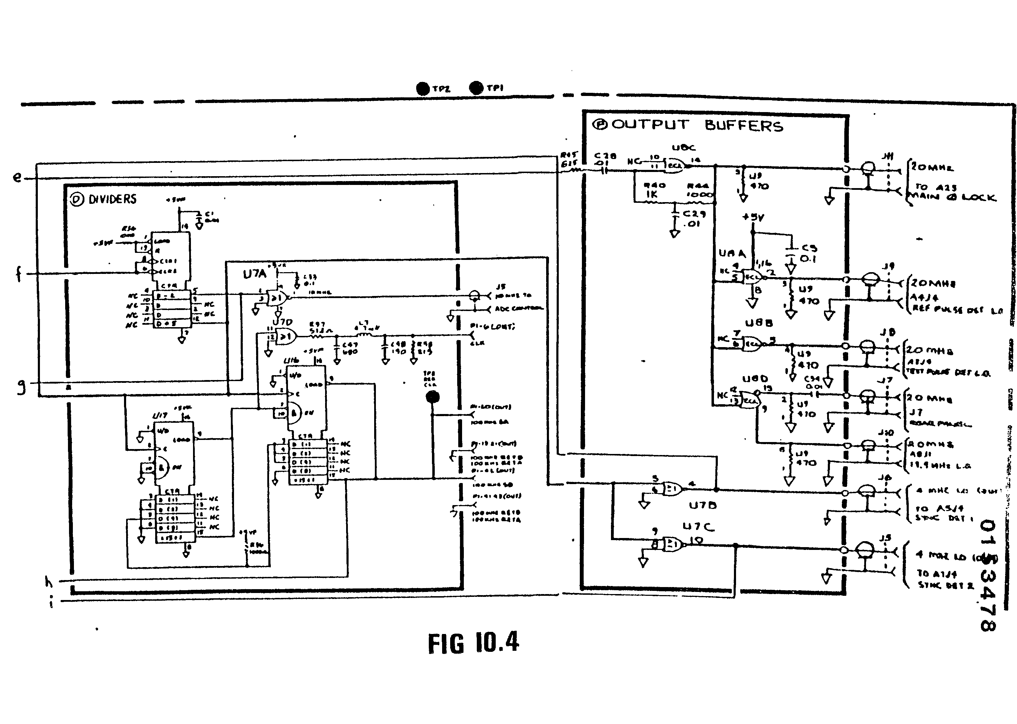

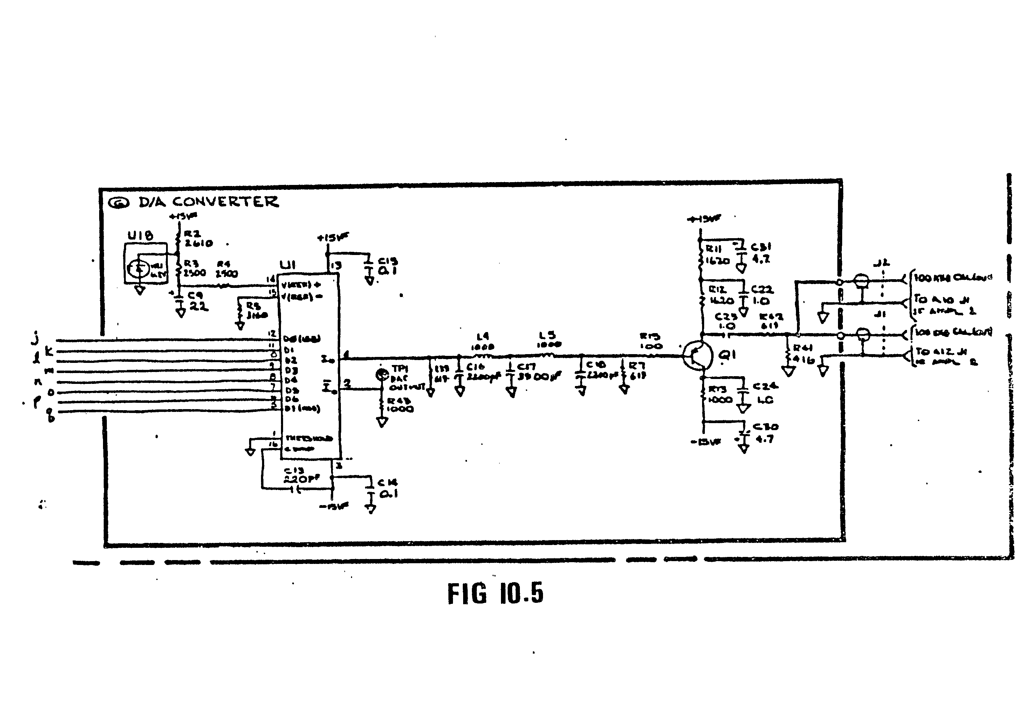

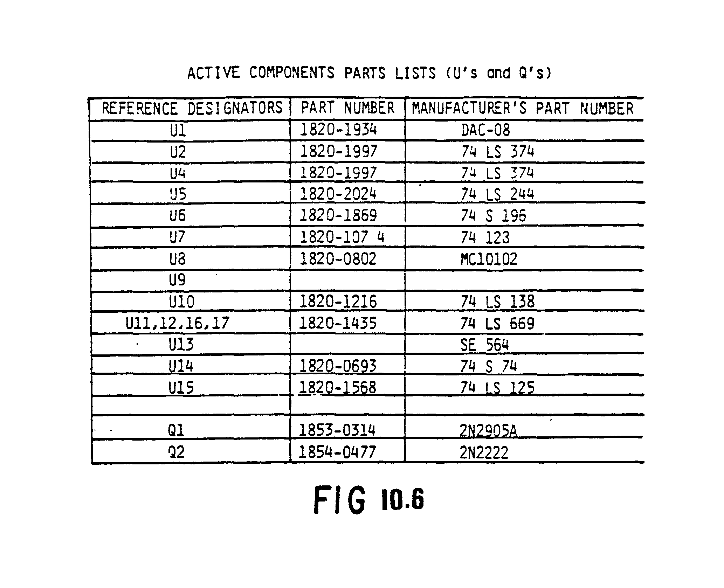

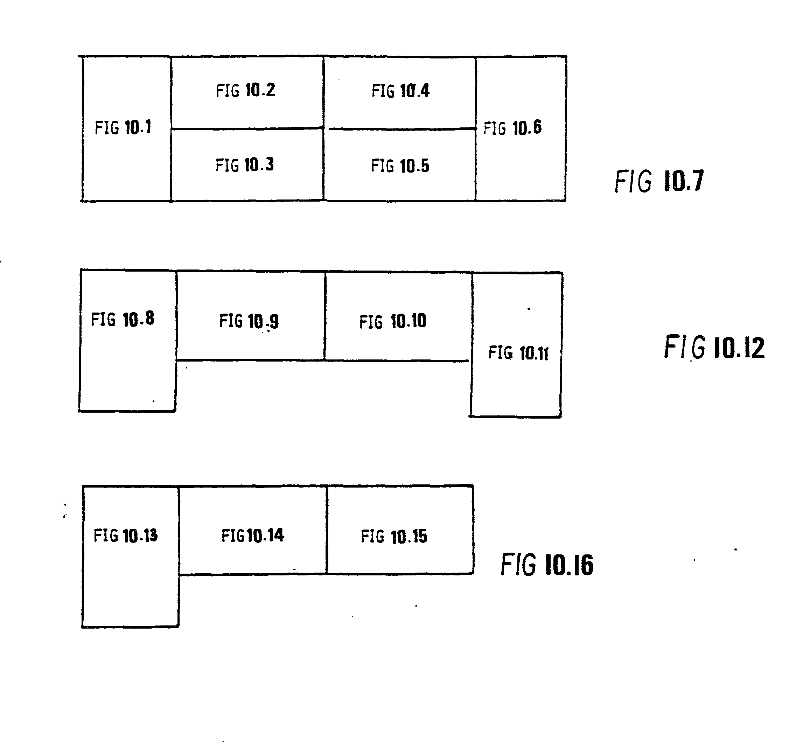

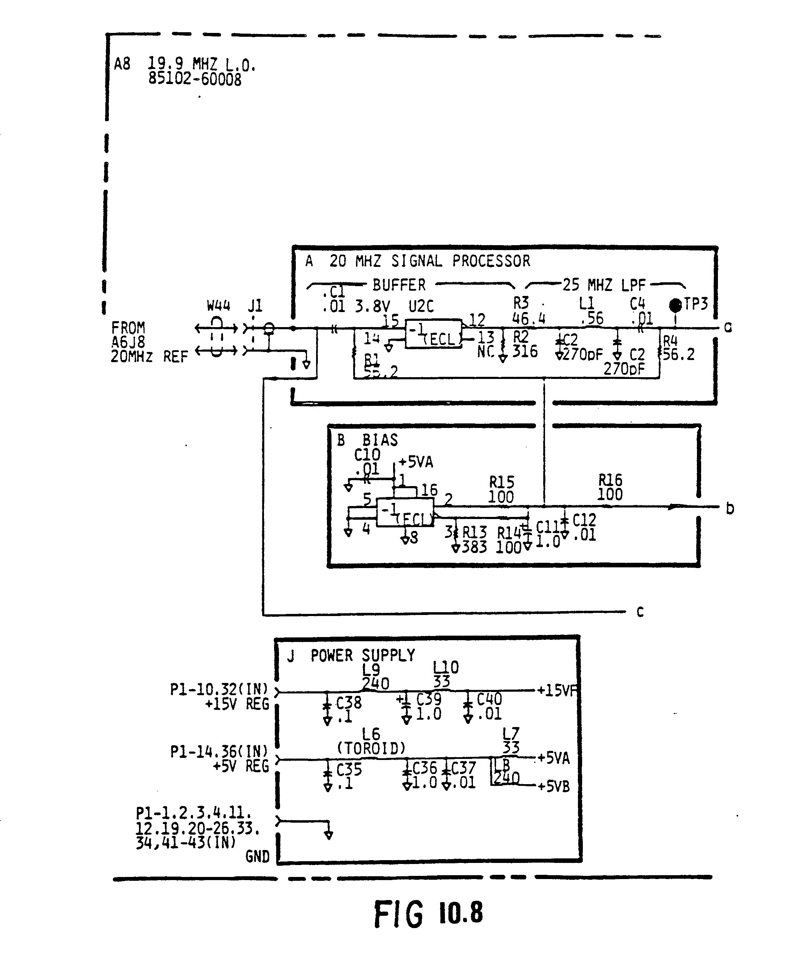

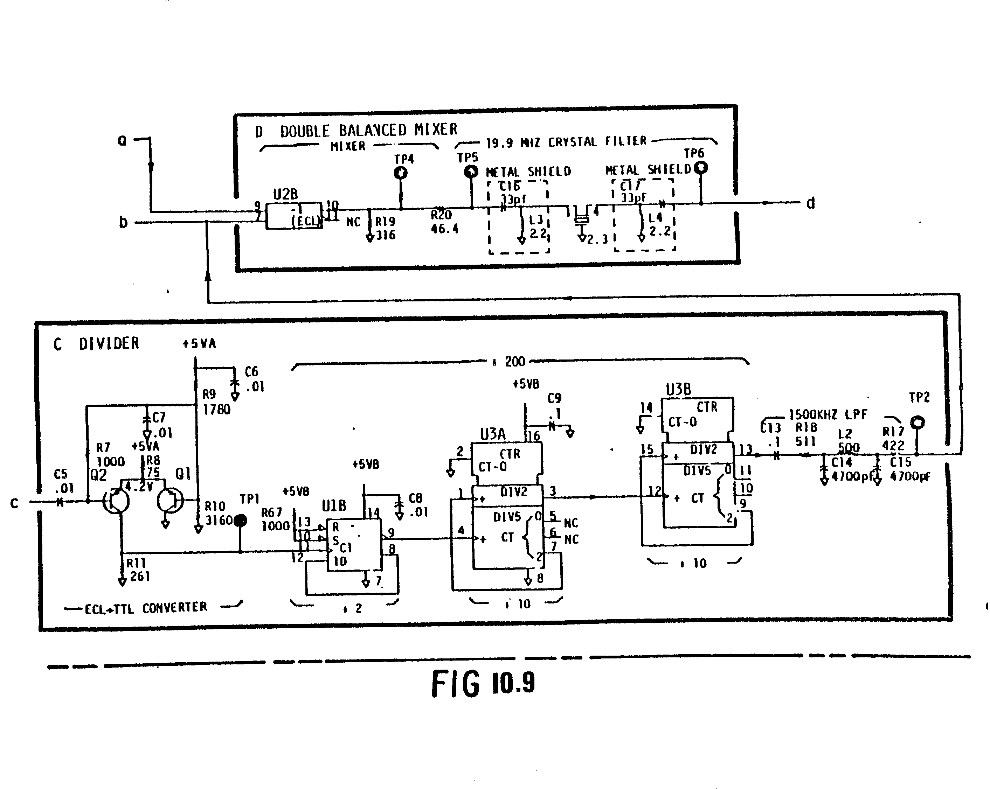

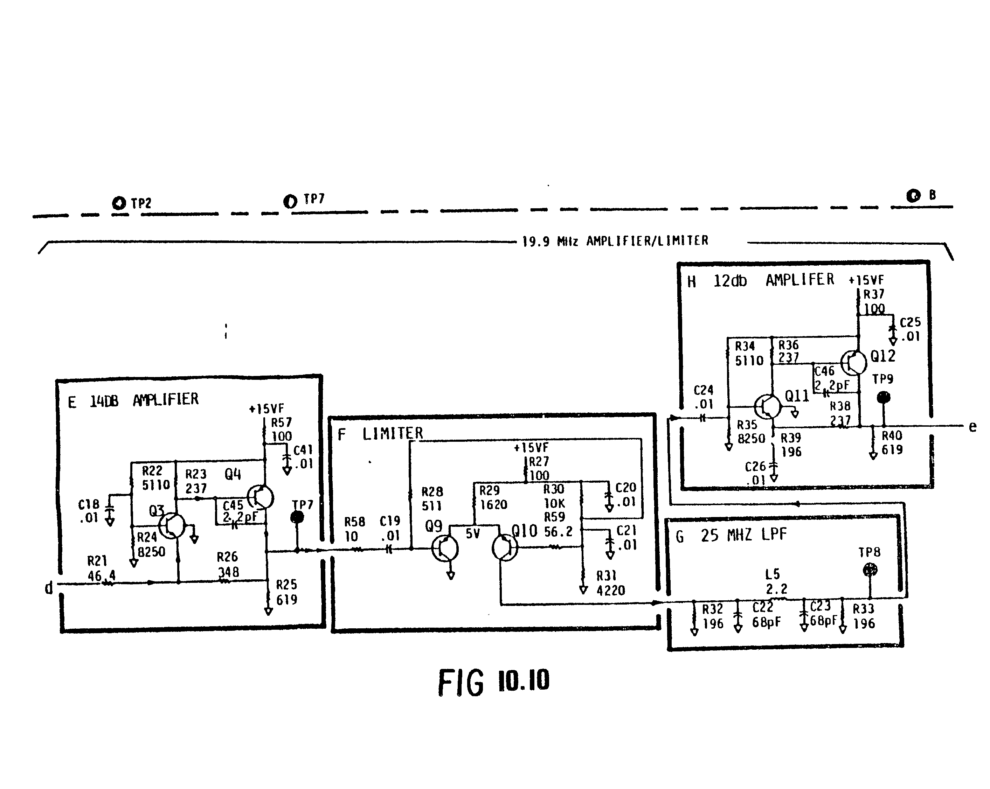

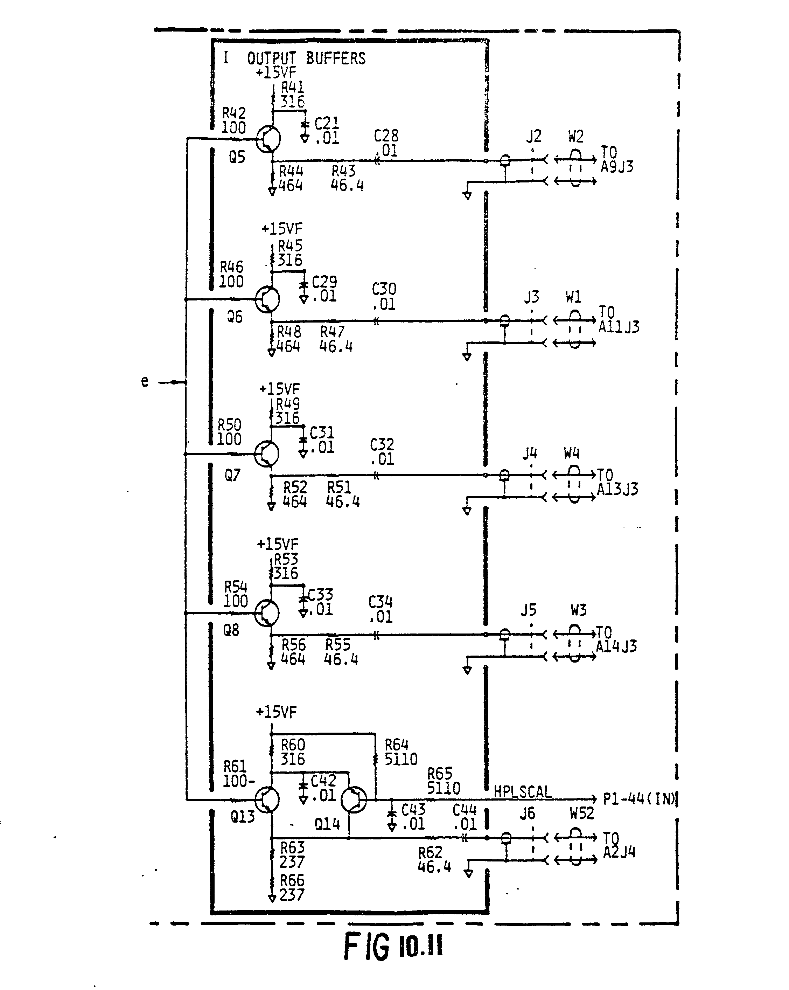

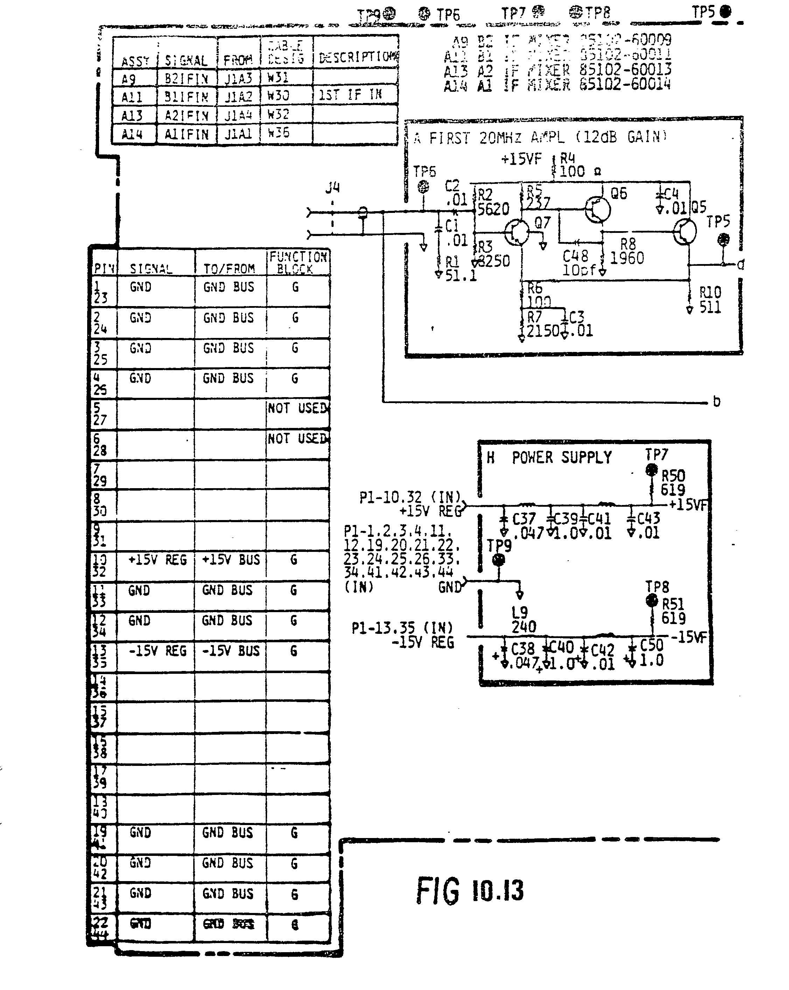

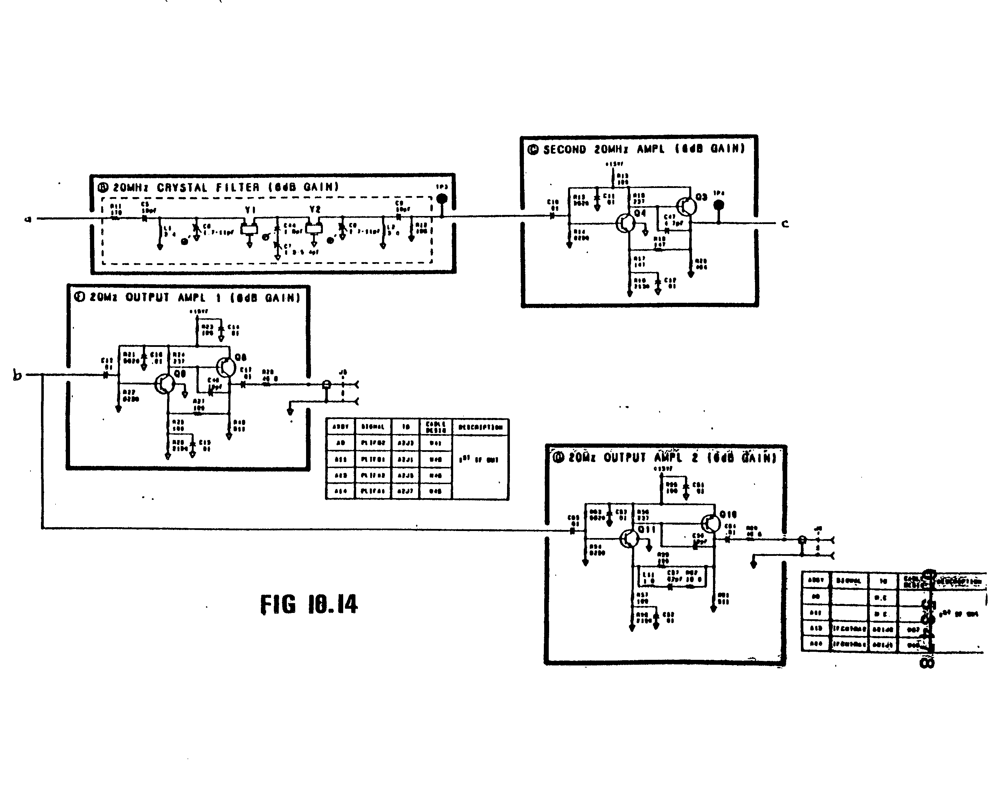

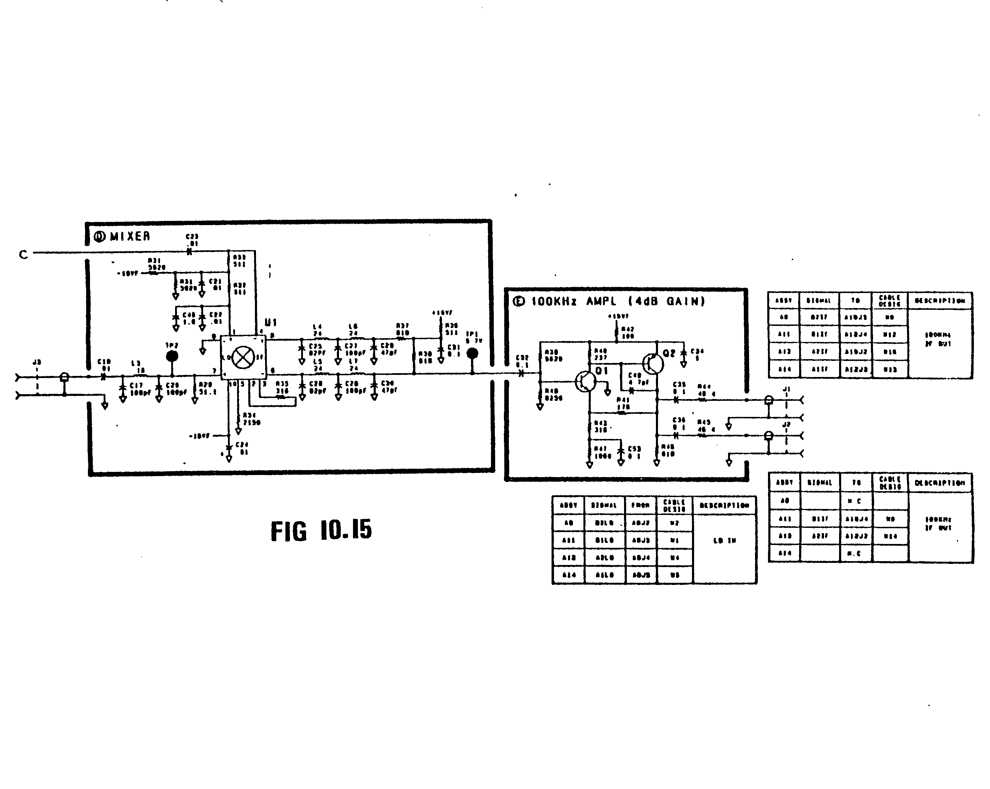

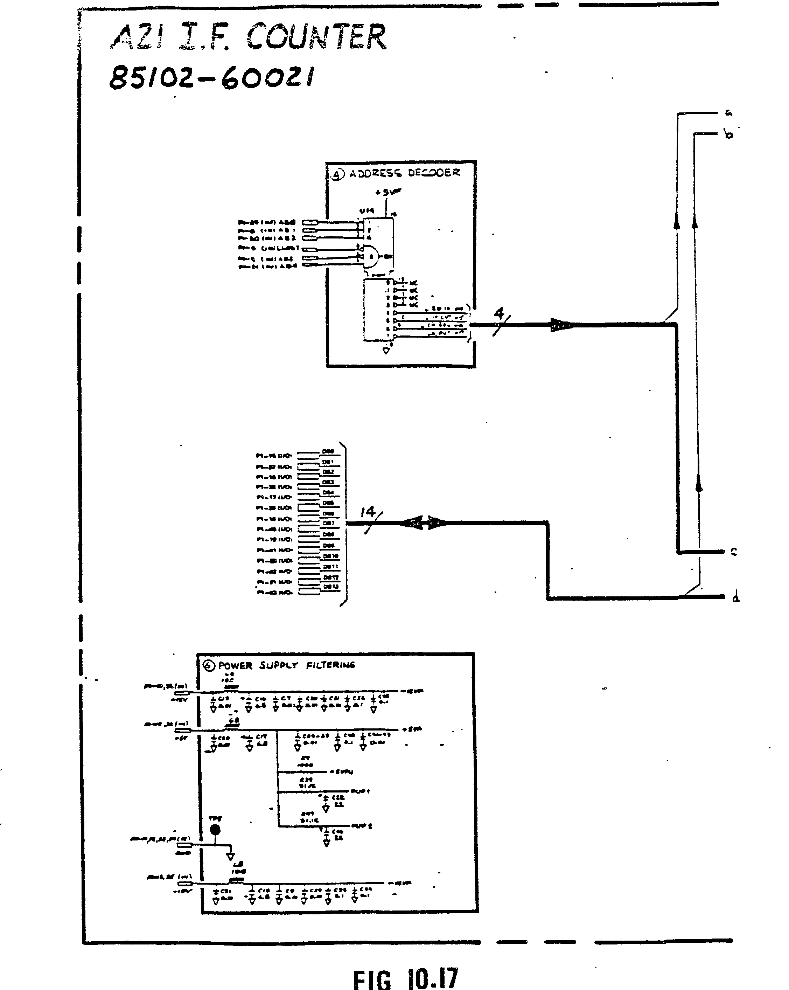

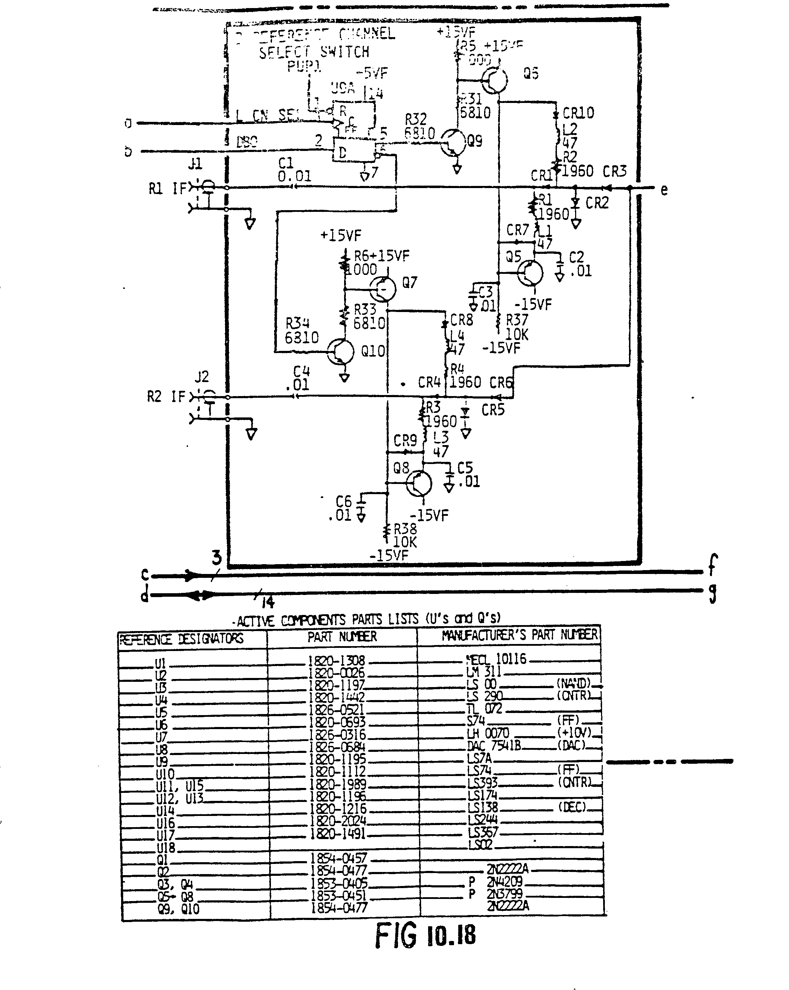

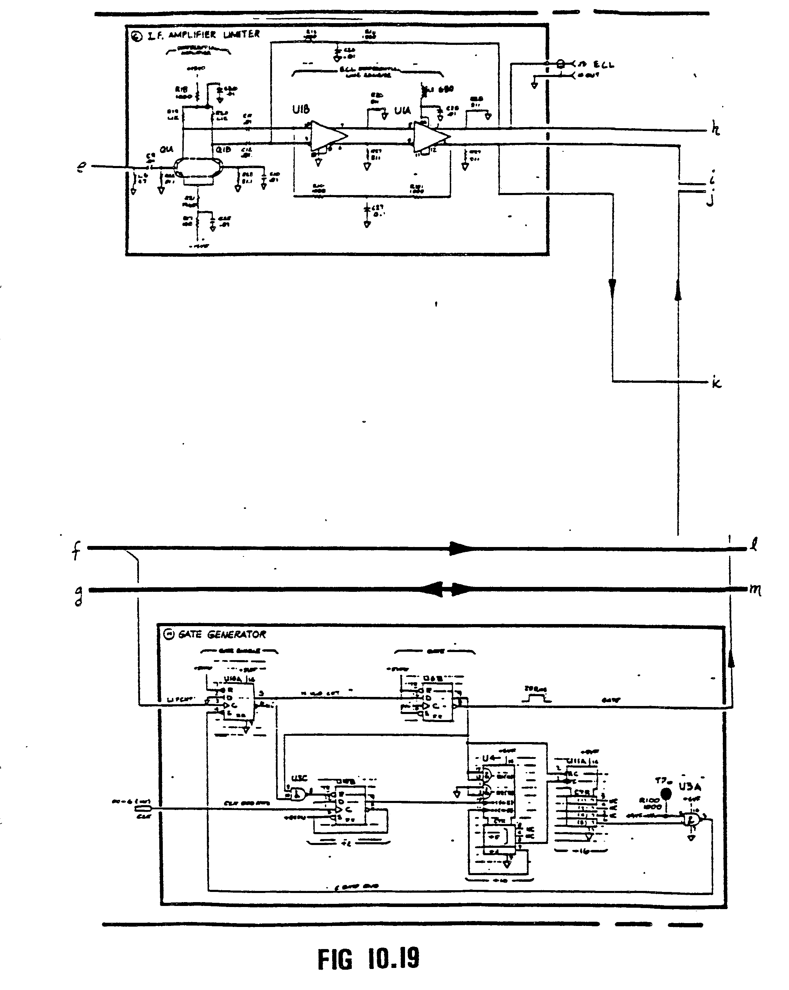

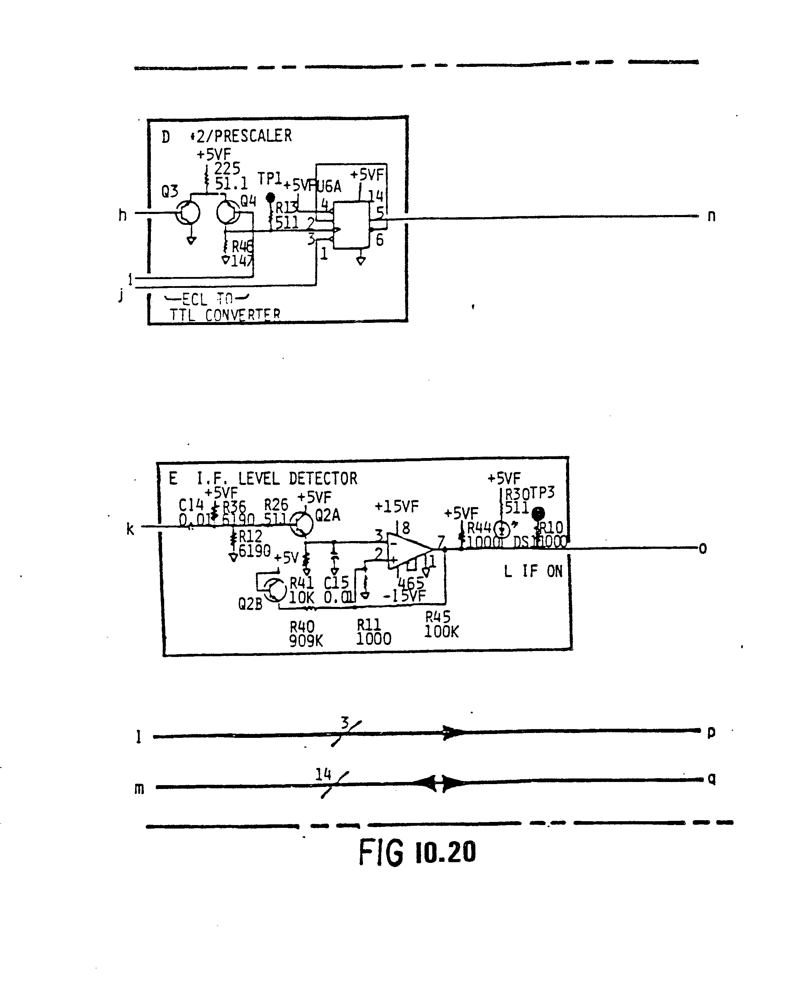

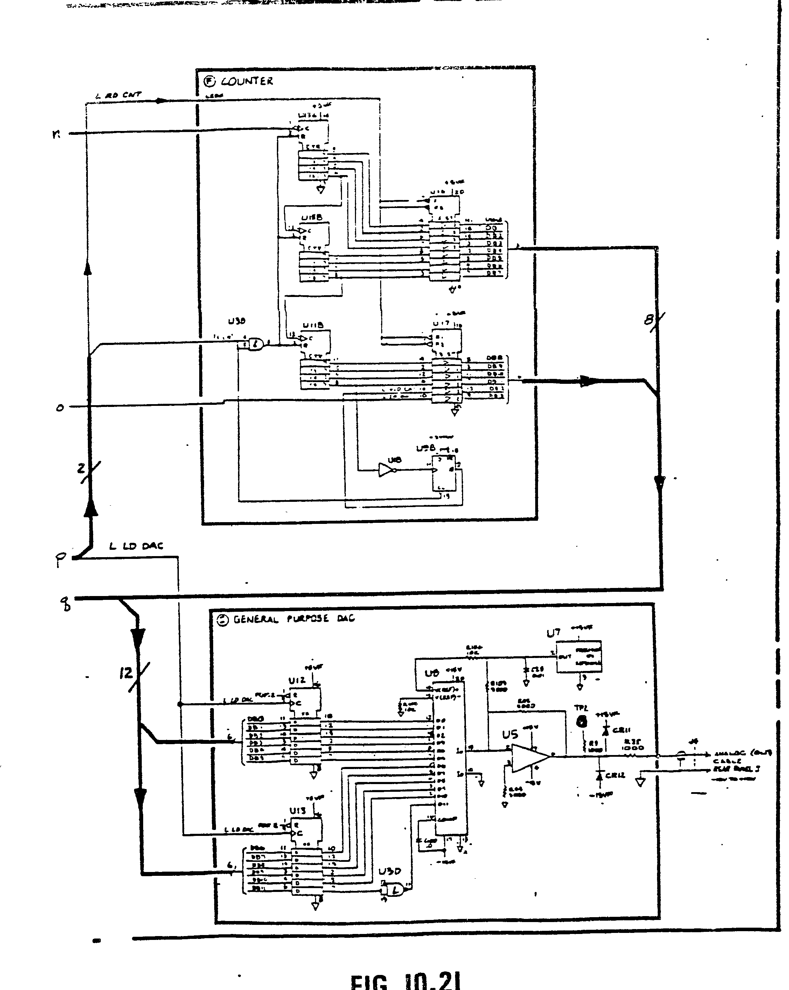

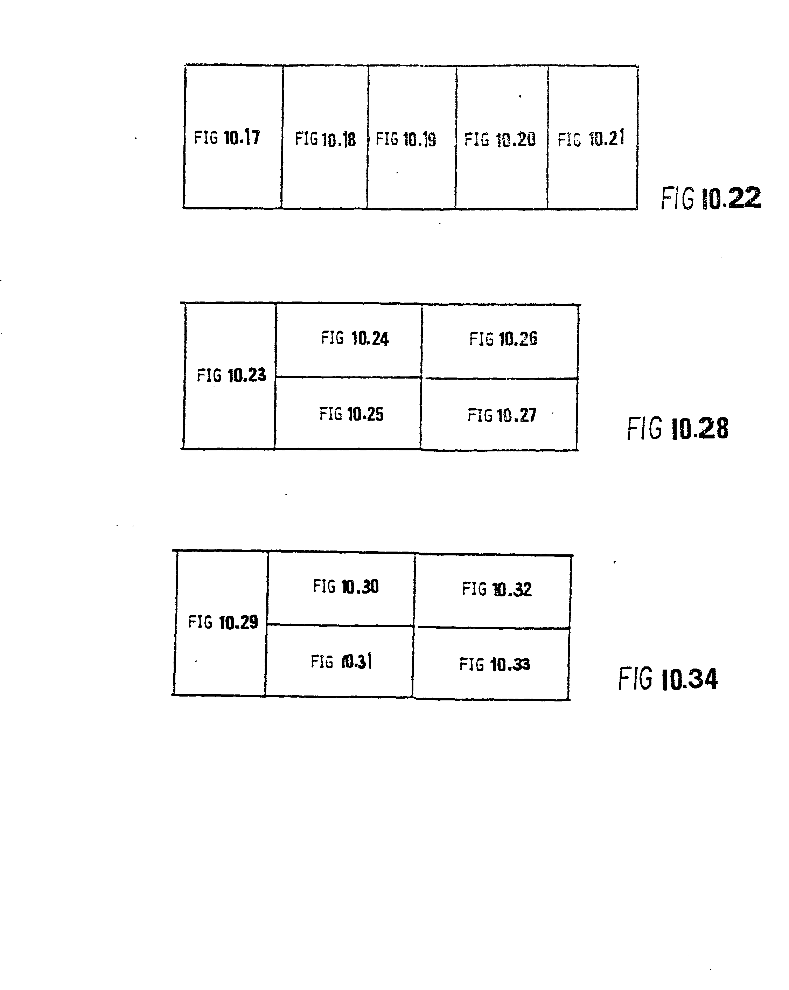

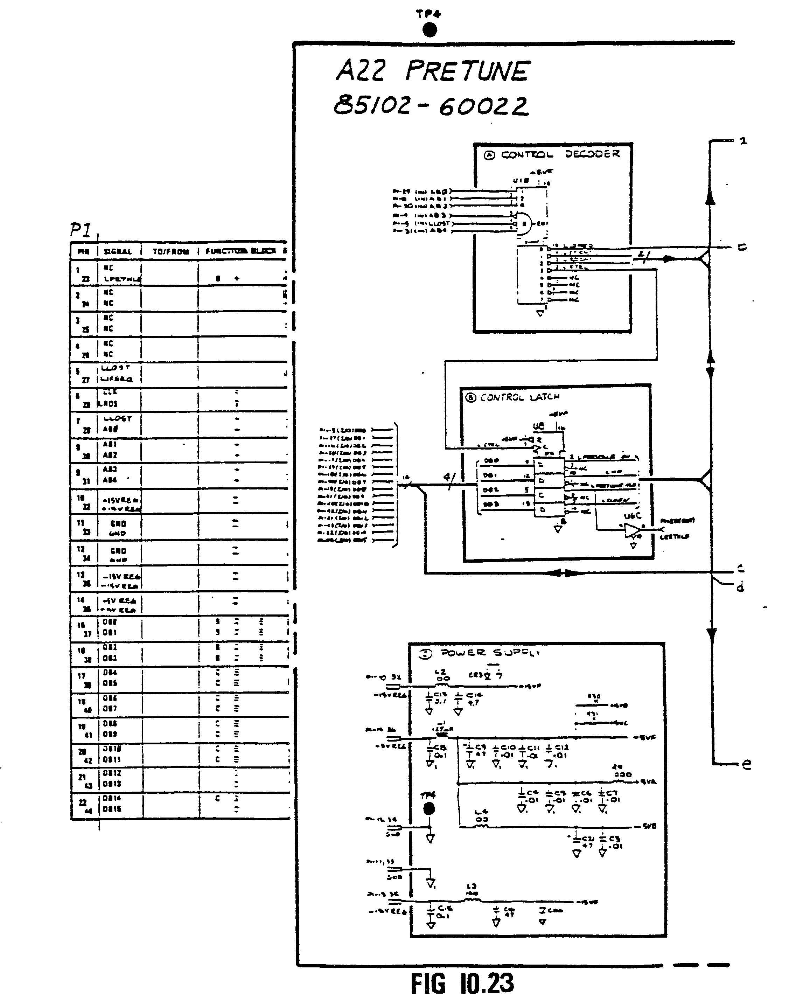

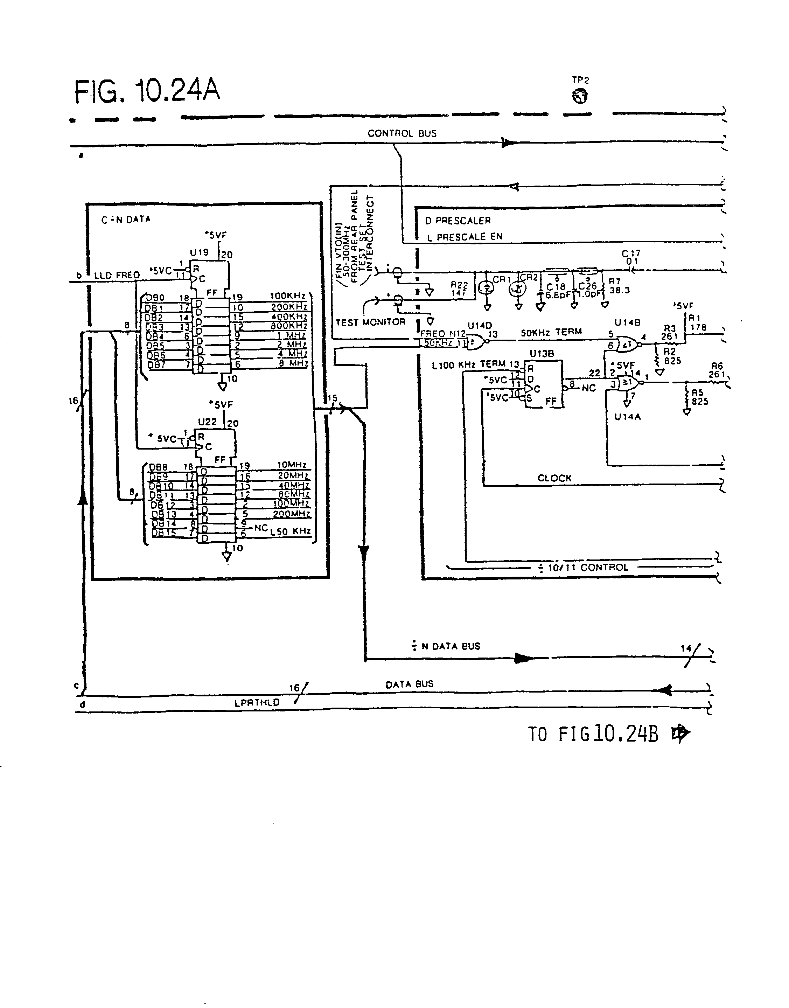

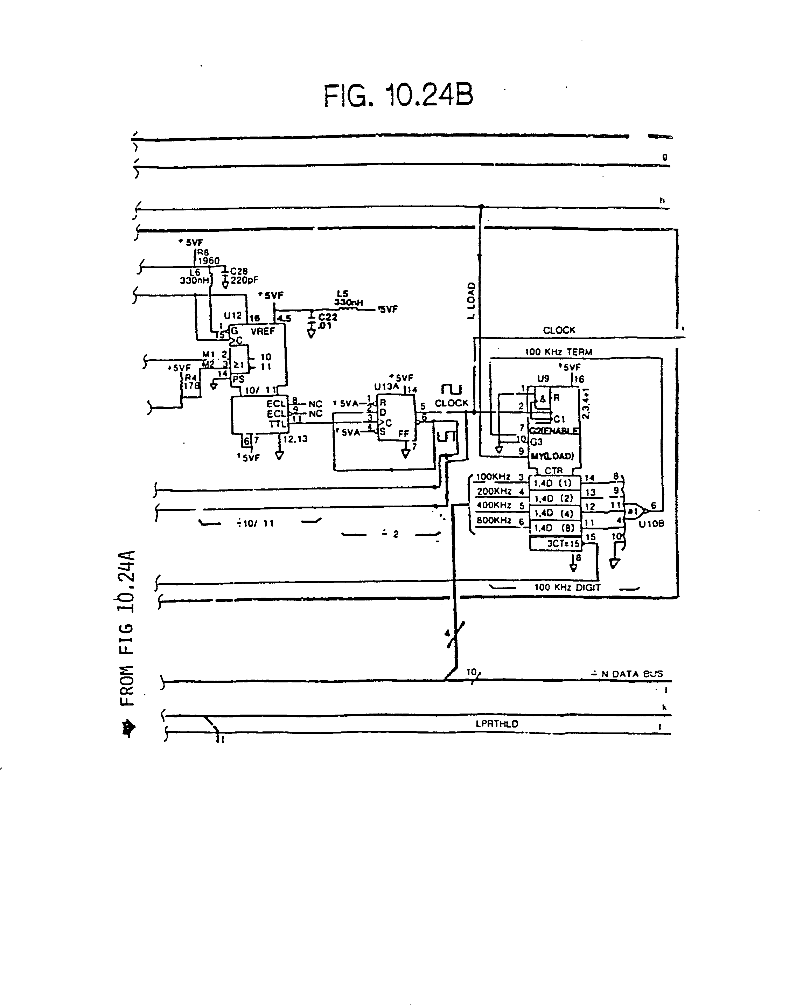

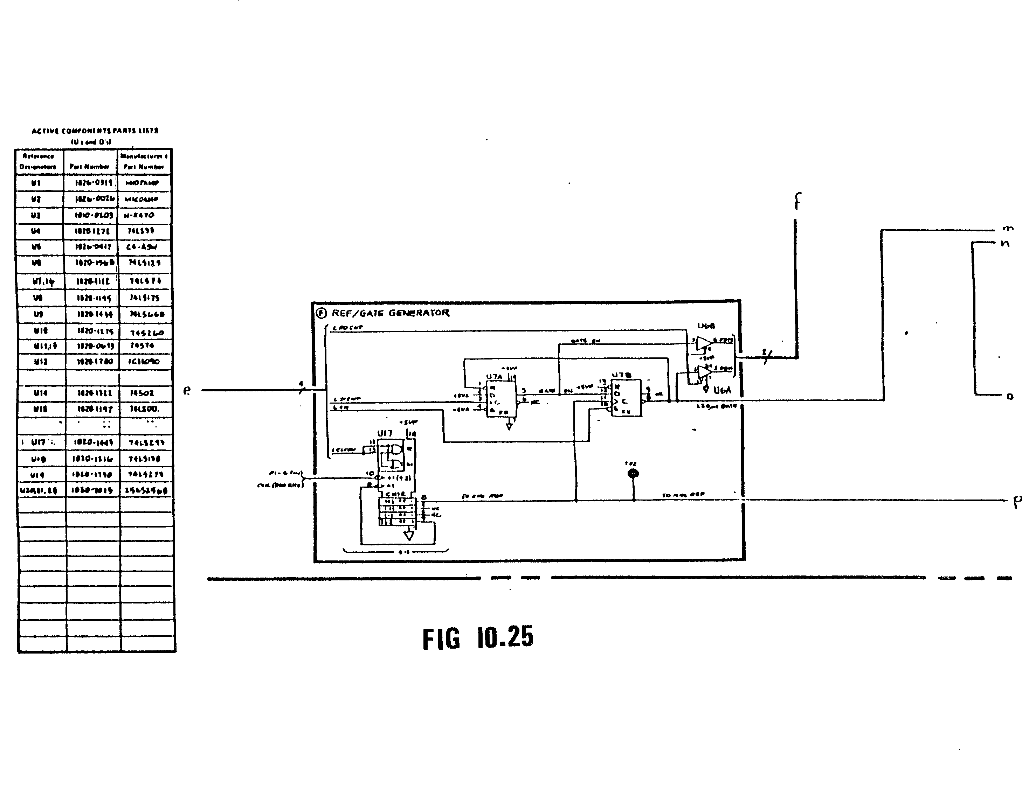

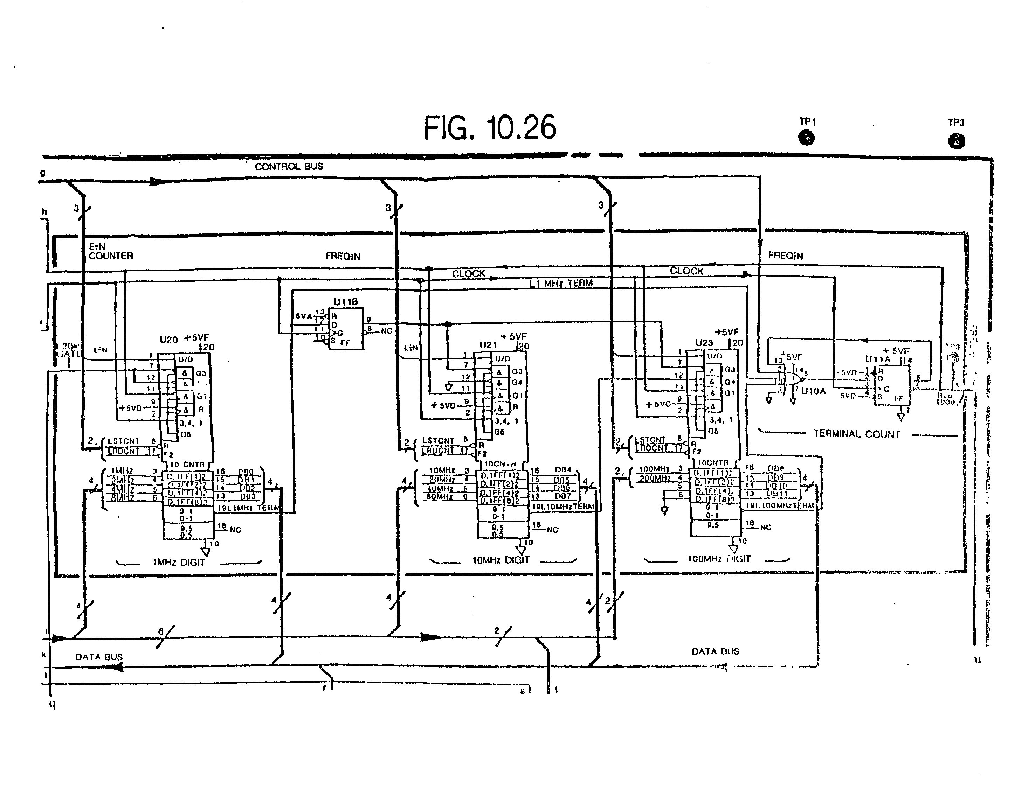

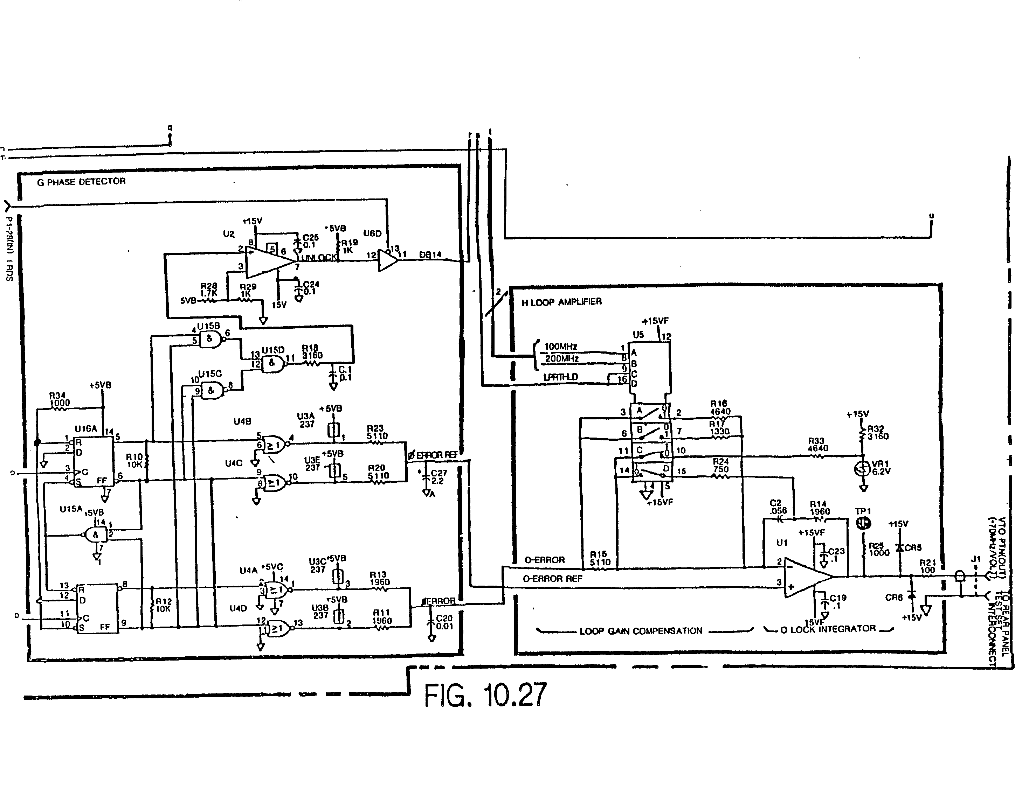

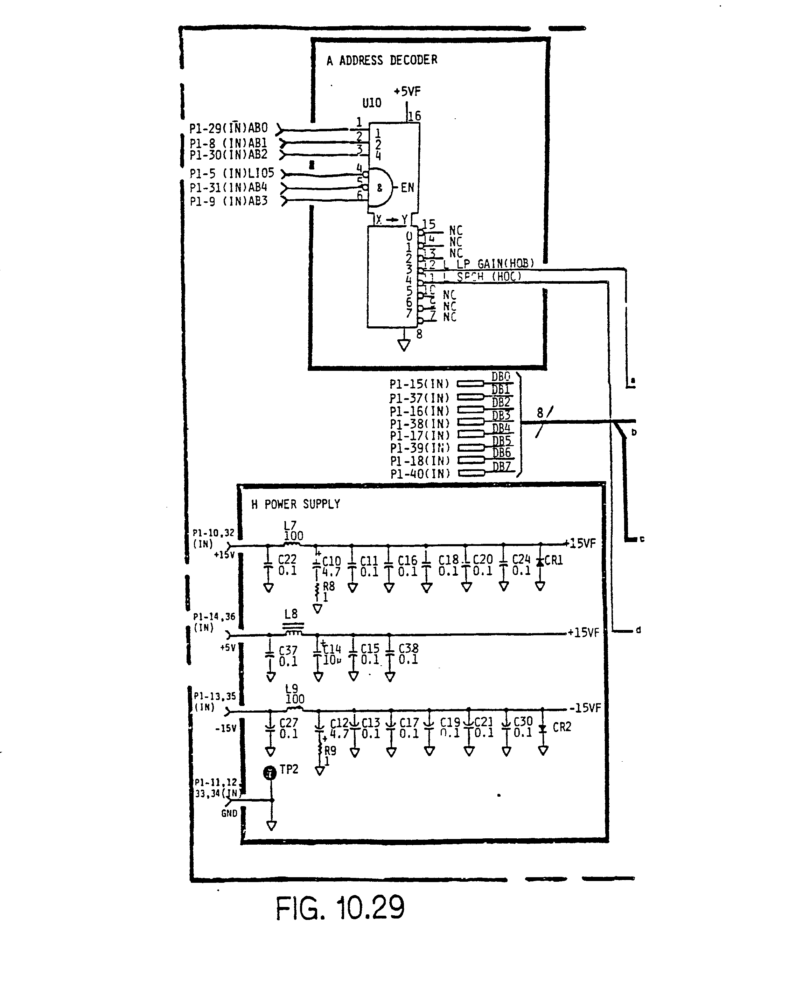

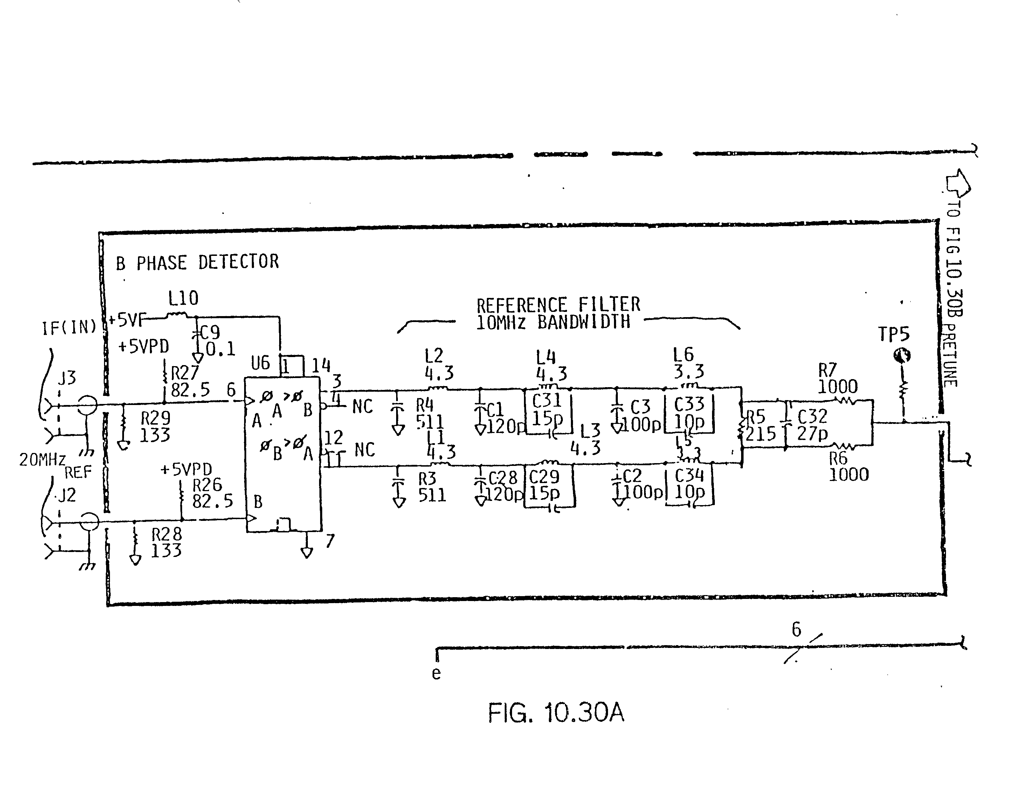

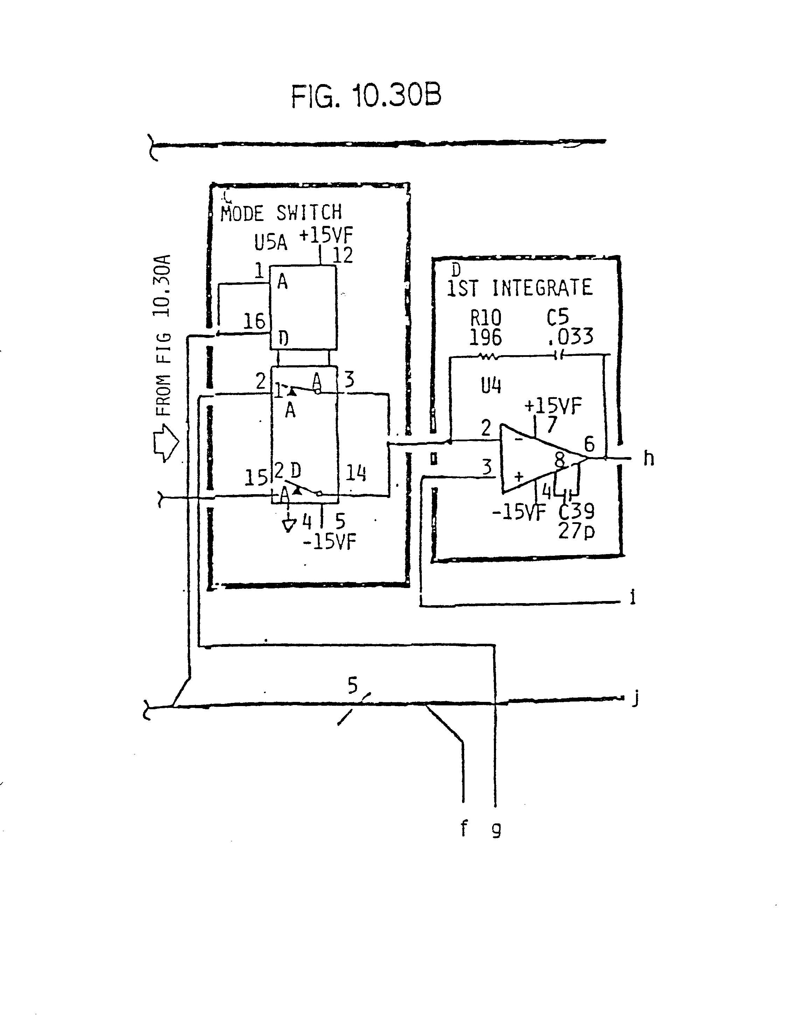

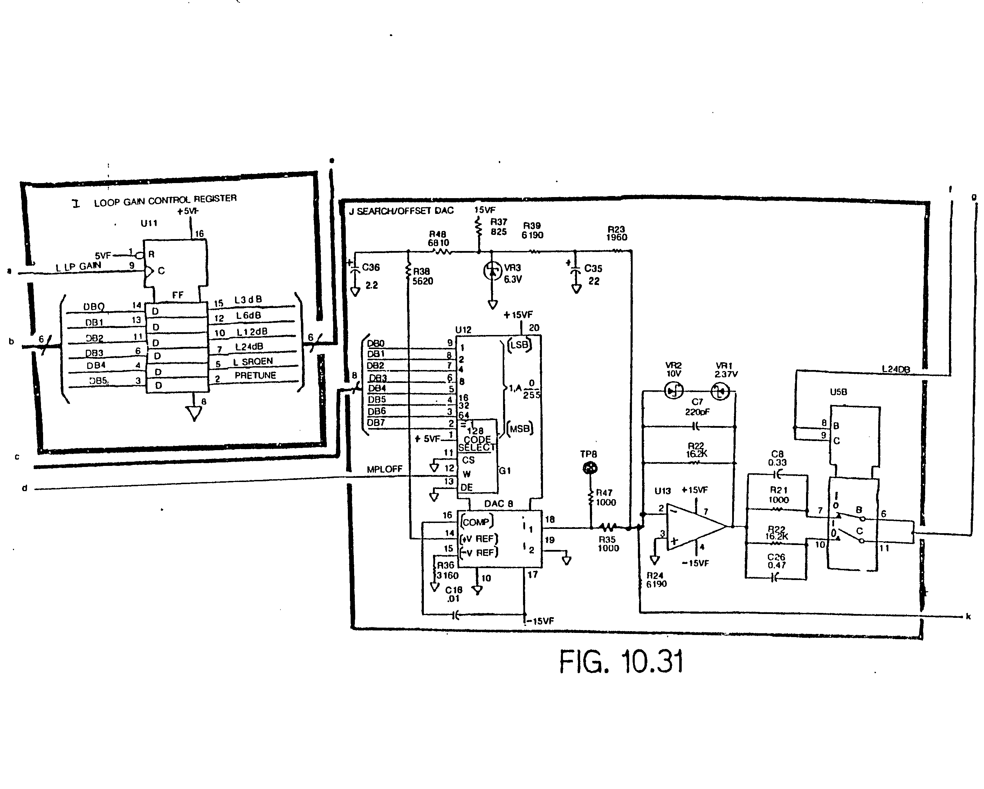

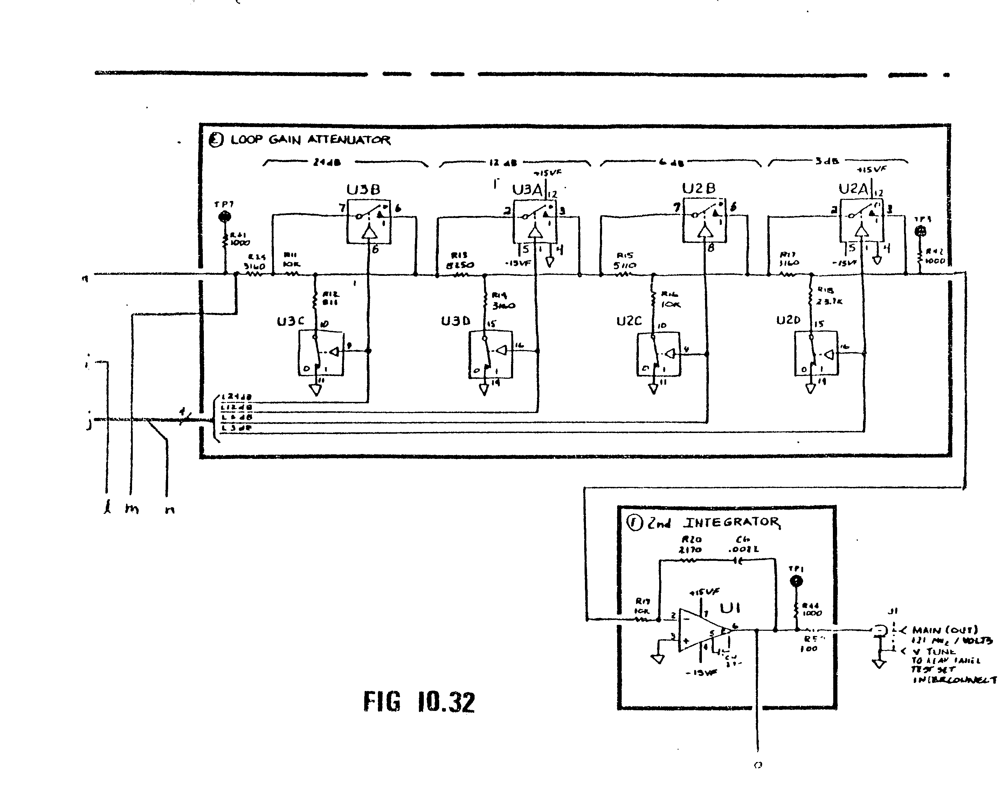

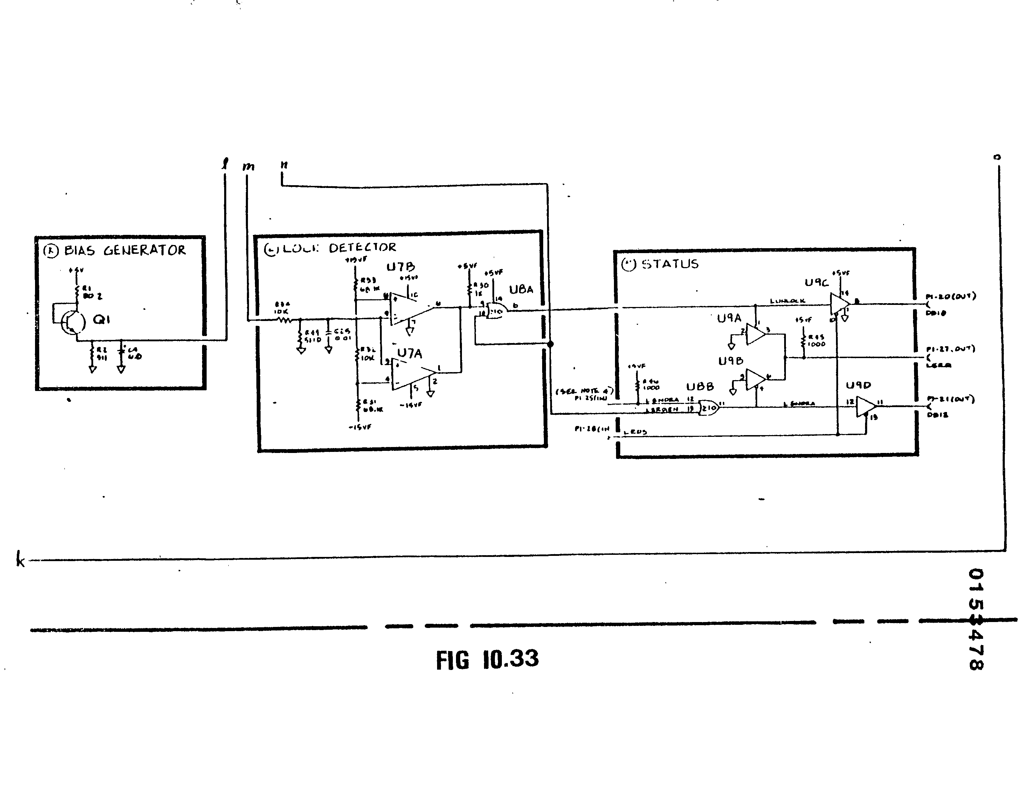

Figures 10.1 through 10.34 show detailed schematics for selected parts of the block diagrams shown in figures 8.1 through 8.6. Figures 10.1 through 10.7 show the clock 119, figures 10.8 through 10.12 show the 19.9 MHz local oscillator 2511, figures 10.13 through 10.16 show the second IF mixer 138, figures 10.17 through 10.22 show the IF counter 2513, figures 10.23 through 10.28 show the VTO pretune circuitry 2515, and figures 10.29 through 10.34 show the main phase lock circuitry 2517.

Software Signal Processing

Signal processing in the present RF vector network analyzer begins at the output of the synchronous detector pair 131 and 133 which provide the real (X) and imaginary (Y) parts of the test and reference signals. As explained previously, offset, gain, and quadrature errors are corrected for both of the IF/detector chains via software. The resulting test and reference data is then ratioed to produce the appropriate S-parameters and stored.

Using a one term model (vector frequency response normalization), a three term model (one port model), and up to twelve term error correction model (comprehensive two port) of the microwave measurement hardware, vector error correction software in conjunction with the vector math processor 151 provides corrected data.

The vector data may be formatted into magnitude, phase, or other formats as desired and stored for providing convenient access for scale and offset changes. Scaled data is stored in the display RAM 217 from which the display generator 153 hardware repetitively creates a plot on the CRT 149 for a flicker-free display. Input and output access is provided via the HP-IB interface 157 and via tape 161. Direct printer and plotter output for the printer, or plotter, 155 may be made.

The software is structured as a multi-tasking system to provide a rapid data update rate by allowing data processing to take place when the data acquisition software is not busy. Overlying command and control tasks interleave data processing with data acquisition cycles.

## Claims

1. A circuit for a radio frequency (RF) network analyzer, comprising:

an RF input port for receiving an RF signal;

signal separation means (108) coupled to the RF input port and comprising switch means for routing the RF signal as an RF stimulus to a device under test; and

frequency converter means (113) coupled to the signal separation means for converting RF signals to IF signals, characterized in that said signal separation means (108) is arranged for reversibly routing said RF stimulus to first and second test ports for connection to the device under test and includes

an electronic reversing switch (2109) coupled to the RF input port;

said first and second test ports being coupled to said reversing switch (2109);

first sampling means coupled to the first test port for deriving a first RF test signal (b1) from an RF response from the device under test appearing at the first test port;

second sampling means coupled to the second test port for deriving a second RF test signal (b2) from an RF response from the device under test appearing at the second test port;

a first reference path coupled to the RF signal path between the reversing switch and the first test port for providing a first RF reference signal (a1); and a second reference path coupled to the RF signal path between the reversing switch and the second test port for providing a second RF reference signal (a2);

said frequency converter (113) converting respectively the first and second RF reference signals and the first and second RF test signals respectively to first and second intermediate frequency (IF) reference signals and first and second IF test signals.

2. A circuit as in claim 1, characterized in that said electronic reversing switch (2109) included in said signal separation means (108) is a PIN diode switch.

3. A circuit as in claim 1 or 2, characterized in that the frequency converter (113) includes phase-locking means (125) having a first input port for receiving a reference oscillator (119) signal, and a second input port (121) for receiving a signal to be phase-locked to the reference oscillator (119) signal.

4. A circuit as in claim 3, characterized in that the circuit further comprises selection means (123) coupled to the frequency converter (113) and arranged for selectably coupling the second input port (121) of the phase-locking means (125) to the first IF reference signal or to the second IF reference signal for selectable phase-locking of the first IF reference signal or the second IF reference signal to the reference oscillator (119) signal.

5. A circuit as in claim 4, characterized in that the selection means (123) comprises an electronic switch.

6. A circuit as in one of claims 1 through 5, characterized in that the first and second sampling means comprise directional couplers (2201).

7. A circuit as in one of claims 1 through 5, characterized in that the first and second sampling means comprise directional bridges (1901).

8. A circuit as in claim 4 or 5, characterized by controlling means (143) adapted to jointly actuate the signal separation means (108) and the electronic reversing switch (2109) and the selection means (123) in a complete measurement of the S-parameters of the device under test.

## Patentansprüche

1. Schaltung für einen Hochfrequenz(HF)-Netzwerk-Analysator mit:

einem HF-Eingangs-Port zum Empfangen eines HF-Signales;

einer mit dem HF-Eingangs-Port gekoppelten Signaltrenneinrichtung (108) mit einer Schalteinrichtung zum Leiten des HF-Signales als eine HF-Anregung an ein zu testendes Gerät;

und mit einer mit der Signaltrenneinrichtung gekoppelten Frequenz-Wandlereinrichtung (113) zur Umwandlung von HF-Signalen in Zwischenfrequenz(ZF)-Signale, dadurch gekennzeichnet,

daß die Signaltrenneinrichtung (108) zum umschaltbaren Leiten der HF-Anregung an einen ersten und zweiten Test-Port zur Verbindung mit dem zu testenden Gerät eingerichtet ist

und einen elektronischen Umschalter (2109) enthält, der mit dem HF-Eingangs-Port gekoppelt ist;

daß der erste und zweite Test-Port mit dem Umschalter (2109) gekoppelt sind;

daß eine erste Abtasteinrichtung mit dem ersten Test-Port gekoppelt ist, um ein erestes HF-Test-Signal (b1) von einer HF-Antwort aus dem zu testenden Gerät, die am ersten Test-Port erscheint, abzuleiten;

daß eine zweite Abtasteinrichtung mit dem zweiten Test-Port gekoppelt ist, um ein zweites HF-Test-Signal (b2) von einer HF-Antwort aus dem zu testenden Gerät, die am zweiten Test-Port erscheint, abzuleiten;

daß ein erster Referenz-Pfad mit dem HF-Signal-Pfad zwischen dem Umschalter und dem ersten Test-Port zur Bereitstellung eines ersten HF-Referenz-Signales (a1) gekoppelt ist;

daß ein zweiter Referenz-Pfad mit dem HF-Signal-Pfad zwischen dem Umschalter und dem zweiten Test-Port zur Bereitstellung eines zweiten HF-Referenz-Signales (a2) gekoppelt ist;

und daß der Frequenzwandler (113) das erste bzw. zweite HF-Referenz-Signal und das erste bzw. zweite HF-Test-Signal in eine erstes bzw. zweites ZF-Referenz-Signal und ein erstes bzw. zweites ZF-Test-Signal wandelt.

2. Schaltung nach Anspruch 1, dadurch gekennzeichnet, daß der elektronische Umschalter (2109), der in der Signaltrenneinrichtung (108) enthalten ist, ein PIN-Dioden-Schalter ist.

3. Schaltung nach Anspruch 1 oder 2, dadurch gekennzeichnet, daß der Frequenzwandler (113) eine Phase-Lock-Einrichtung (125) mit einem ersten Eingangs-Port zum Empfangen eines Signales von einem Referenz-Oszillator (119) und einem zweiten Eingangs-Port (121) zum Empfangen eines Signales, dasmit dem Signal aus dem Referenz-Oszillator (119) phasenstarr zu koppeln ist, enthält.

4. Schaltung nach Anspruch 3, dadurch gekennzeichnet, daß die Schaltung außerdem eine Auswahleinrichtung (123) umfaßt, die mit Frequenzwandler (113) gekoppelt ist, und zur wahlweisen Kopplung des zweiten Eingangs-Ports (121) der Phase-Lock-Einrichtung (125) mit dem ersten ZF-Referenz-Signal oder mit dem zweiten ZF-Referenz-Signal zum wählbaren phasenstarren Koppeln des ersten ZF-Referenz-Signales oder des zweiten ZF-Referenz-Signales mit dem Signal des Referenz-Oszillators (119) eingerichtet ist.

5. Schaltung nach Anspruch 4, dadurch gekennzeichnet, daß die Auswahleinrichtung (123) einen elektronischen Schalter aufweist.

6. Schaltung nach einem der Ansprüche 1 bis 5, durch gekennzeichnet, daß die erste und zweite Abtasteinrichtung Richtkoppler (2201) enthalten.

7. Schaltung nach einem der Ansprüche 1 bis 5, dadurch gekennzeichnet, daß die erste und zweite Abtasteinrichtung Richtbrücken (1901) enthalten.

8. Schaltung nach Anspruch 4 oder 5, gekennzeichnet durch eine Steuereinrichtung (13), die zum gemeinsamen Betätigen der Signaltrenneinrichtung (108), des elektronischen Umschalters (2109) und der Auswahleinrichtung (123) in einer kompletten Messung der S-Parameter des zu testenden Gerätes geeignet ist.

**Revendiations**

1. Un circuit pour un analyseur de réseau radiofréquence (RF), comprenant:

un port d'entrée RF, destiné à recevoir un signal RF,

des moyens séparateurs de signal (108), reliés au port d'entrée RF et comprenant des moyens de commutation permettent de diriger le signal RF vers un dispositif à tester, pour lequel il constitue un stimulus RF, et

des moyens convertisseurs de fréquence (113), reliés aux moyens séparateurs de signal, pour convertir les signaux RF en signaux à fréquence intermédiaire,

caractérisé en ce que lesdits moyens séparateurs de signal (108) sont conçus de manière à acheminer de façon réversible le stimulus RF vers un premier et un second port de test destinés à être reliés à l'appareil à tester, et comprennent:

un commutateur électronique d'inversion (2109), relié au port d'entrée RF,

le premier et le second port de test étant reliés à de commutateur d'inversion (2109),

des premiers moyens d'échantillonnage, reliés au premier port de test, permettent d'obtenir un premier signal RF de test (b1) à partir d'une réponse RF apparaissant au premier port de test depuis le dispositif à tester,

des seconds moyens d'échantillonnage, reliés au second port de test, permettant d'obetenir un second signal RF de test (b2) à partir d'une réponse RF apparaissant au second port de test depuis le dispositif à tester,

un premier trajet de référence, relié au trajet du signal RF allant de commutateur d'inversion au premier port de test, permettant de délivrer un premier signal RF de référence (a1), et

un second trajet de référence, relié au trajet du signal RF allant du commutateur d'inversion au second port de test, permettant de délivrer un second signal RF de référence (a2),

ledit convertisseur de fréquence (113) convertissant, respectivement, le premier et le second signal RF de référence et le premier et le second signal RF de test en un premier et un second signal à fréquence intermédiaire (FI) de référence et en un premier et un second signal FI de test.

2. Le circuit de la revendication 1, caractérisé en ce que le commutateur électronique d'inversion (2109) faisant partie des moyens séparateurs de signal (108) est un commutateur à diode PIN.

3. Le circuit de l'une des revendications 1 ou 2, caractérisé en ce que le convertisseur de fréquence (113) comporte des moyens à verrouillage de phase (125) avec un premier port d'entrée recevant un signal d'oscillateur de référence (119) et un second port d'entrée (121) recevant un signal à verrouiller en phase au signal de l'oscillateur de référence (119).

4. Le circuit de la revendication 3, caractérisé en ce que le circuit comporte en outre des moyens sélecteurs (123), reliés au convertisseur de fréquence (113) et conçus de manière à relier sélectivement le second port d'entrée (121) des moyens à verrouillage de phase (125) au premier signal FI de référence ou au second signal FI de référence, afin de permettre un verrouillage en phase sélectif du premier signal FI de référence ou du second signal FI de référence sur le signal de l'oscillateur de référence (119).

5. Le circuit de la revendication 4, caractérisé en ce que les moyens sélecteurs (123) comportent un commutateur électronique.

6. Le circuit de l'une des revendications 1 à 5, caractérisé en ce que les premiers et seconds moyens d'échantillonnage comportent des coupleurs directionnels (2201).

7. Le circuit de l'une des revendications 1 à 5, caractérisé en ce que les premiers et seconds moyens d'échantillonnage des ponts directionnels (1901).

8. Le circuit de l'une des revendications 4 ou 5, caractérisé par des moyens de commande (143) conçus pour activer concurremment les moyens séparateurs de signal (108), le commutateur électronique d'inversion (2109) et les moyens de sélection (123) lors d'une mesure complète des paramètres-S du dispositif à tester.

FIG 1

FIG 2b

FIG 2a

FIG 4

EP 0 153 478 B1

FIG 3

FIG 5

4

FIG 6

A2 IF MULTIPLEXER (OPTION 001)
08513-60004

| PIN | SIGNAL | TO/FROM | FUNCTION BLOCK |
|---|---|---|---|
| 1 23 | | | |
| 2 24 | IF1 IF2 | DC NC | B |
| 3 25 | | | |
| 4 26 | | | |
| 5 27 | LBIOS | A4 | A |
| 6 28 | PWON | A13 | B |
| 7 29 | AB0 | A4 | A |
| 8 30 | AB1 AB2 | A4 A4 | A |
| 9 31 | AB3 AB4 | A4 A4 | A |
| 10 32 | +15V REG | A15 | G |
| 11 33 | GND | GND BUS | G |
| 12 34 | GND | GND BUS | G |
| 13 35 | -15V REG | A15 | G |
| 14 36 | +5V REG | A15 | G |
| 15 37 | DB0 DB1 | A4 A4 | B |
| 16 38 | DB2 DB3 | A4 A4 | B |
| 17 39 | | | |
| 18 40 | DB6 DB7 | A4 A4 | B |
| 19 41 | | | |
| 20 42 | IF MUX | A3 | A |
| 21 43 | | | |
| 22 44 | | | |

FIG 7.1

FIG 7.2

7

FIG 7.3

FIG 7.1 FIG 7.2 FIG 7.3

FIG 7.4

FIG 7.5 FIG 7.6 FIG 7.7 FIG 7.8 FIG 7.9

FIG 7.10

FIG 7.11 FIG 7.12 FIG 7.13 FIG 7.14 FIG 7.15

FIG 7.16

FIG 7.17 FIG 7.18 FIG 7.19 FIG 7.20

FIG 7.21

FIG 7.22 FIG 7.23

FIG 7.24

EP 0 153 478 B1

FIG 7.5

10

FIG 7.6

● TP7　　　　● TP4

○ SOKHz REF FILTER

TP7

R1
2610

L1
33H

R34
1606

C2
4700PF

C3
4700
PF

R2
2610

c

g

h

d

○ VTO SENSE SELECT BUFFER

+5VF

+5VF
R29
1476

USA

+5VF　+15VF

R30
422

L6
6.33

R47
1600
PF

R38
16K

TP4

+5VF
R26
1476

Q31

C18
1000
PF

Q1

R12
14.7K

USB

USC

C5
1000
PF

Q7

e

C25
1000PF

U1A

R31
398

PTW
CR2

C24
1000PF

INT VTO SENSE

50 Ω

R52
422

R54
1000

R55
16K

Q2

R10
14.7K

b

Q8

50 Ω

VTO SENSE OUTPUT

EXT VTO SENSE

50 Ω

C36
1000PF

U2A

R32
398

PTW
CR3

C37
1000PF

C38
1000
PF

R53
422

f

i

FIG 7.7

EP 0 153 478 B1

FIG 7.8

13

FIG 7.9

14

FIG 7.11

FIG 7.12

MEMORY

CONTROL BUS

DATA BUS

CONTROL BUS

DATA BUS

**FIG 7.13**

**FIG 7.14**

EP 0 153 478 B1

FIG 7.15

19

FIG 7.17

## FIG 7.18

s
t
u
v
w
x
y
z

o'
p'
q'
r'
s'
t'
u'
v'

a'
b'
c'
d'
e'
f'
g'
h'

TO PORT 1
ATTENUATOR

TO PORT 1
REFERENCE
EXTENSION

J8    J2

A18
SWITCH/
SPLITTER

W?    J6

i'
j'

J5
← RF IN

W?    J4

k'
l'

J3

m'
n'

W?

TO PORT 2
REFERENCE
EXTENSION

J1    J7

TO PORT 2
ATTENUATOR

w'
x'
y'
z'
a"
b"
c"
d"

FIG 7.19

FIG 7.20

FIG 7.22

FIG 7.23

| | | FIG **8.3** | |
| FIG **8.1** | FIG **8.2** | | FIG **8.5** |
| | | FIG **8.4** | |

*FIG* **8.6**

# FIG. 8.1A

TEST SET 107          SECTION 103

20MHZ

A —— S —— [filter] —— [amp] ——>> b1 20MHZ IF — a
                                      -10dBm

B —— S —— [filter] —— [amp] ——>> b2 20MHZ IF — b
                                      -10dBm

R₁ —— S —— [filter] —— [amp] ——>> a1 20MHZ IF — c
                                      -10dBm

R₂ —— S —— [filter] —— [amp] ——>> a2 20MHZ IF — d
                                      -10dBm

VTO DRIVER

121    115

VTO 50-350 MHZ    Σ    VTO OFFSET
VTO SENSE    Y TUNE

TEST SET INTERCONNECT

127    129    A22 PRETUNE

2515

PTCNT
W

VTO SENSE    20/21/22    3DECADE COUNTER    Ø    ÷ 16    800 KHZ TTL

0dBm 50-300 MHZ

RDPT
R

PTFREQ
W

PTCTL
W

VTO OFFSET    INTE-GRATOR    LOOP GAIN COMPENSATION    LOCK DETECTOR

125

⬇ TO FIG 8.1B

27

FIG. 8.1B

FROM FIG 8.1A

A23 MAIN PHASE LOCK  2517

20MHz REF

LOCK DETECTOR

20MHz VARIABLE

125

INTE-GRATOR

ATTN

MPLCTL W

AUTO ZERO

INTE-GRATOR

V TUNE

DAC

MPLOFF W

A21 IF COUNTER  2513

123

$a_1$

$a_2$

PHASE LOCK IN

LEVEL DETECTOR

AUX OUT

DAC

AOUT W

800KHz TTL

12 BIT COUNTER

RDIF R

IFCNT W

ECL LEVELS:  0.8V P-P

TTL LEVELS: ⊃2.7V P-P

NOTE:

SIGNAL LEVELS ARE MEASURED WITH
-10dBm INPUT FROM TEST SET TO 85102
AND ALL IF GAINS SET TO MINIMUM.

28

FIG. 8.2

132

A5 TEST SYNCHRONOUS DETECTOR 133

a'

Σ

35KHz/
1KHz

4MHz
L.O.

2505

SIN
GEN

DAC

x₂

a"

0-360°
SHIFT

100KHz
SYNC

TSTPHA

COS
GEN

DAC

35KHz/
1KHZ

y₂

b"

c"

b'

d"

A7 REF SYNCHRONOUS DETECTOR 131

e"

c'

Σ

35KHz/
1KHz

130

4MHz
L.O.

2505

SIN
GEN

DAC

x₁

0-360°
SHIFT

100KHz
SYNC

REFPHA

COS
GEN

DAC

35KHz/
1KHz

y₁

d'
e'
f'

**FIG 8.3**

k"

k'

l"

l'

300 KHz TTL

m"

A1 FRONT PANEL 159

KEYBOARD
DECODER

RD KEY

LED 0

FRONT
PANEL
LEDS

KEY-
BOARD

m'
n'

LED 1

LED 2

KEY
DEBOUNCE

o'

n"

p'

o"

**FIG 8.4**

# FIG. 8.5A

EP 0 153 478 B1

FROM FIG 8.5A ⇩

FIG. 8.5B

EP 0 153 478 B1

**FIG 9.1**

$$\begin{bmatrix} X \\ Y \end{bmatrix} = \begin{bmatrix} H_{11} & H_{12} \\ H_{21} & H_{22} \end{bmatrix}_{[H]} \begin{bmatrix} X_m - X_0 \\ Y_m - Y_0 \end{bmatrix}$$

**FIG 9.2**

$$X_0 = \frac{1}{4}\Sigma X_m \quad ; \quad y_0 = \frac{1}{4}\Sigma Y_m$$

**FIG 9.3**

$$1)\ \begin{bmatrix} X \\ Y \end{bmatrix}_{0°} = \begin{bmatrix} A \\ 0 \end{bmatrix} ; 2)\begin{bmatrix} X \\ Y \end{bmatrix}_{90°} = \begin{bmatrix} 0 \\ A \end{bmatrix} ; 3)\begin{bmatrix} X \\ Y \end{bmatrix}_{180°} = \begin{bmatrix} -A \\ 0 \end{bmatrix} ; 4)\begin{bmatrix} X \\ Y \end{bmatrix}_{270} = \begin{bmatrix} 0 \\ -A \end{bmatrix}$$

**FIG 9.4**

$$\begin{bmatrix} 1 \\ 0 \\ 0 \\ 1 \end{bmatrix}_{A} \begin{bmatrix} H_{11} \\ H_{12} \\ H_{21} \\ H_{22} \end{bmatrix} = \frac{A}{\Sigma(X^2)\Sigma(Y^2) - (\Sigma(xy))^2} \cdot \begin{bmatrix} 0 & -(Y_1-Y_3) & (X_1-X_3) \\ (Y_1-Y_3) & -(X_1-X_3) & 0 \\ 0 & -(Y_2-Y_4) & (X_2-X_4) \\ (Y_2-Y_4) & -(X_2-X_4) & 0 \end{bmatrix} \begin{bmatrix} \Sigma(x^2) \\ \Sigma(xy) \\ \Sigma(y^2) \end{bmatrix}$$

**FIG 9.5**

$$a_1 = A \cdot \left[ \frac{(X_1-X_3) + (Y_2-Y_4)}{\Sigma(X^2) + \Sigma(Y^2)} \right]$$

$$b_1 = A \cdot \left[ \frac{(X_2-X_4) + (Y_3-Y_1)}{\Sigma(X^2) + \Sigma(Y^2)} \right]$$

**FIG 9.6**

# A6 CLOCK
# 85102-60006

**A6 CLOCK**

P1

| PIN | SIGNAL | TO/FROM | FUNCTION BLOCK |
|---|---|---|---|
| 1 | | | |
| 23 | | | |
| 2 | LTSDS | A5 | (A) |
| 24 | LRSDS | A7 | (A) |
| 3 | LTIFWS | A10 | (A) |
| 25 | LRIFWS | A12 | (A) |
| 4 | LTIFRS | A10 | (A) |
| 26 | LRIFRS | A12 | (A) |
| 5 | LHOST | ADR BUS | (A) |
| 27 | LFSRQ | | |
| 6 | CLK | A5-A14 | (F) |
| 28 | LRD4 | | |
| 7 | GND | | |
| 29 | A Ø | ADR BUS | (A) |
| 8 | A1 | ADR BUS | (A) |
| 30 | A2 | ADR BUS | (A) |
| 9 | A3 | ADR BUS | (A) |
| 31 | A4 | ADR BUS | (A) |
| 10 32 | +15V REG | POWER BUS | (I) |
| 11 33 | GND | | (I) |
| 12 34 | GND | | (I) |
| 13 35 | -15V REG | POWER BUS | (I) |
| 14 36 | +5V REG | POWER BUS | (I) |
| 15 37 | BUF DBØ BUF DB1 | DATA BUS " | (C) (C) |
| 16 38 | BUF DB2 BUF DB3 | " " | (C) (C) |
| 17 39 | BUF DB4 BUF DB5 | " " | (C) (C) |
| 18 40 | BUF DB6 BUF DB7 | " " | (C) (C) |
| 19 41 | 100KHz RETB | A5,A7 | (B) (F) |
| 20 42 | 100K SA 100K SB | A5 A7 | (E) (E) |
| 21 43 | 100KHz RETA | A5,A7 | (F) (F) |
| 22 44 | | | |

(A) 100KHz IF
ADDRESS DECODER

+5V
C27
.01

U10
16

P1-29 (IN) AØ
P1-8 (IN) A1
P1-30 (IN) A2
P1-5 (IN) LHOST
P1-31 (IN) A4
P1-9 (IN) A3

EN

P1-4 (OUT) TIFRS
P1-3 (OUT) TIFWS
P1-2 (OUT) TSDS
P1-24 (OUT) RSDS
P1-25 (OUT) RIFWS
P1-26 (OUT) RIFRS

a

(H) POWER SUPPLY

P1-10,32 (IN)
L2 100
+15V REG
C7 C11
.01
+15VR

P1-14,36 (IN)
L1
+5V REG
C6 C9
.01
+5VR

P1-11,12,33,34
GND

P1-13,35 (IN)
L3 100
-15V REG
C8 C12
0.1 0.1
-15VR

b

# FIG 10.1

FIG 10.2

FIG 10.3

FIG 10.4

D/A CONVERTER

FIG 10.5

38

ACTIVE COMPONENTS PARTS LISTS (U's and Q's)

| REFERENCE DESIGNATORS | PART NUMBER | MANUFACTURER'S PART NUMBER |
|---|---|---|
| U1 | 1820-1934 | DAC-08 |
| U2 | 1820-1997 | 74 LS 374 |
| U4 | 1820-1997 | 74 LS 374 |
| U5 | 1820-2024 | 74 LS 244 |
| U6 | 1820-1869 | 74 S 195 |
| U7 | 1820-107 4 | 74 123 |
| U8 | 1820-0802 | MC10102 |
| U9 | | |
| U10 | 1820-1216 | 74 LS 138 |
| U11,12,16,17 | 1820-1435 | 74 LS 669 |
| U13 | | SE 564 |
| U14 | 1820-0693 | 74 S 74 |
| U15 | 1820-1568 | 74 LS 125 |
| | | |
| Q1 | 1853-0314 | 2N2905A |
| Q2 | 1854-0477 | 2N2222 |

# FIG 10.6

| | FIG **10.2** | FIG **10.4** | |
| FIG **10.1** | | | FIG **10.6** |
| | FIG **10.3** | FIG **10.5** | |

FIG **10.7**

| FIG **10.8** | FIG **10.9** | FIG **10.10** | FIG **10.11** |

FIG **10.12**

| FIG **10.13** | FIG **10.14** | FIG **10.15** |

FIG **10.16**

**EP 0 153 478 B1**

A8  19.9 MHZ L.O.
85102-60008

FROM
A6J8
20MHz REF

W44  J1

A  20 MHZ SIGNAL PROCESSOR

BUFFER ——————  ———— 25 MHZ LPF ————

.C1
.01  3.8V  U2C

R3 .
46.4

L1
.56

C4
.01

TP3

15

-1
ECL

12

13  R2
NC. 316

C2
270pF

C2
270pF

R4
56.2

14

R1
55.2

a

B  BIAS

C10
.01

+5VA

R15
100

R16
100

1

5

-1
ECL

16  2

b

4

8

3 R13
383

R14
100

C11
1.0

C12
.01

c

J  POWER SUPPLY

L9
240

L10
33

P1-10.32(IN)
+15V REG

C38
.1

C39
1.0

C40
.01

+15VF

L6
(TOROID)

L7
33

P1-14.36(IN)
+5V REG

C35
.1

C36
1.0

C37
.01

L8
240

+5VA

+5VB

P1-1.2.3.4.11.
12.19.20-26.33.
34,41-43(IN)

GND

## FIG 10.8

FIG 10.9

FIG 10.10

19.9 MHz AMPLIFIER/LIMITER

E 14DB AMPLIFIER

F LIMITER

G 25 MHZ LPF

H 12db AMPLIFIER

**FIG 10.11**

TP9 ⊕  ⊕ TP6  TP7 ⊕  ⊕ TP8  TP5 ●

| ASSY | SIGNAL | FROM | CABLE DESIG | DESCRIPTION |
|------|--------|------|-------------|-------------|
| A9 | B2IFIN | J1A3 | W31 | |
| A11 | B1IFIN | J1A2 | W30 | 1ST IF IN |
| A13 | A2IFIN | J1A4 | W32 | |
| A14 | A1IFIN | J1A1 | W36 | |

A9 B2 IF MIXER 85102-60009
A11 B1 IF MIXER 85102-60011
A13 A2 IF MIXER 85102-60013
A14 A1 IF MIXER 85102-60014

A FIRST 20MHZ AMPL (12dB GAIN)

J4

+15VF R4 100 Ω
TP5
C2 .01  R2 5620  R5 237  Q6  C4 .01  Q5  TP5
C1 .01  R3 8250  Q7  C48 10pf  R8 1960
R1 51.1
R6 100
R7 2150  C3 .01
R10 511

| PIN | SIGNAL | TO/FROM | FUNCTION BLOCK |
|-----|--------|---------|----------------|
| 1 / 23 | GND | GND BUS | G |
| 2 / 24 | GND | GND BUS | G |
| 3 / 25 | GND | GND BUS | G |
| 4 / 26 | GND | GND BUS | G |
| 5 / 27 | | | NOT USED |
| 6 / 28 | | | NOT USED |
| 7 / 29 | | | |
| 8 / 30 | | | |
| 9 / 31 | | | |
| 10 / 32 | +15V REG | +15V BUS | G |
| 11 / 33 | GND | GND BUS | G |
| 12 / 34 | GND | GND BUS | G |
| 13 / 35 | -15V REG | -15V BUS | G |
| 14 / 36 | | | |
| 15 / 37 | | | |
| 16 / 38 | | | |
| 17 / 39 | | | |
| 18 / 40 | | | |
| 19 / 41 | GND | GND BUS | G |
| 20 / 42 | GND | GND BUS | G |
| 21 / 43 | GND | GND BUS | G |
| 22 / 44 | GND | GND BUS | G |

b

H POWER SUPPLY  TP7
R50 619
P1-10.32 (IN) +15V REG
C37 .047  C39 1.0  C41 .01  C43 .01  +15VF
P1-1.2.3.4.11.12.19.20.21.22.23.24.25.26.33.34.41.42.43.44 (IN) GND
TP9
TP8
R51 619
L9 240
P1-13.35 (IN) -15V REG
C38 .047  C40 1.0  C42 .01  C50 1.0  -15VF

FIG 10.13

FIG 10.14

FIG 10.15

# A2I I.F. COUNTER
# 85102-60021

**FIG 10.17**

EP 0 153 478 B1

FIG 10.18

## -ACTIVE COMPONENTS PARTS LISTS (U's and Q's)

| REFERENCE DESIGNATORS | PART NUMBER | MANUFACTURER'S PART NUMBER | |
|---|---|---|---|
| U1 | 1820-1308 | ECL 10116 | |
| U2 | 1820-0026 | LM 311 | |
| U3 | 1820-1197 | LS 00 | (NAND) |
| U4 | 1820-1442 | LS 290 | (CNTR) |
| U5 | 1826-0521 | TL 072 | |
| U6 | 1820-0693 | S74 | (FF) |
| U7 | 1826-0316 | LH 0070 | (+10V) |
| U8 | 1826-0684 | DAC 7541B | (DAC) |
| U9 | 1820-1195 | LS7A | |
| U10 | 1820-1112 | LS74 | (FF) |
| U11, U15 | 1820-1989 | LS393 | (CNTR) |
| U12, U13 | 1820-1196 | LS174 | |
| U14 | 1820-1216 | LS138 | (DEC) |
| U16 | 1820-2024 | LS244 | |
| U17 | 1820-1491 | LS367 | |
| U18 | | LS02 | |
| Q1 | 1854-0457 | | |
| Q2 | 1854-0477 | 2N2222A | |
| Q3, Q4 | 1853-0405 | P 2N4209 | |
| Q5, Q8 | 1853-0451 | P 2N3799 | |
| Q9, Q10 | 1854-0477 | 2N2222A | |

FIG 10.19

FIG 10.20

FIG 10.21

| FIG 10.17 | FIG 10.18 | FIG 10.19 | FIG 10.20 | FIG 10.21 |
|---|---|---|---|---|

FIG 10.22

| FIG 10.23 | FIG 10.24 | FIG 10.26 |
|---|---|---|
| | FIG 10.25 | FIG 10.27 |

FIG 10.28

| FIG 10.29 | FIG 10.30 | FIG 10.32 |
|---|---|---|
| | FIG 10.31 | FIG 10.33 |

FIG 10.34

FIG 10.23

# EP 0 153 478 B1

## FIG. 10.24A

TO FIG 10.24B

# FIG. 10.24B

ACTIVE COMPONENTS PARTS LISTS
(U's and Q's)

| Reference Designators | Part Number | Manufacturer's Part Number |
|---|---|---|
| U1 | 1826-0319 | MHOFAMP |
| U2 | 1826-0016 | MHOAMP |
| U3 | 1810-0103 | H-R470 |
| U4 | 1820-1272 | 74LS39 |
| U5 | 1826-0617 | C4-ASW |
| U6 | 1820-1960 | 74LS123 |
| U7,14 | 1820-1112 | 74LS74 |
| U8 | 1820-1195 | 74LS175 |
| U9 | 1820-1434 | 74LS668 |
| U10 | 1820-1275 | 74S260 |
| U11,13 | 1820-0619 | 74S74 |
| U12 | 1820-1780 | IC16090 |
| U14 | 1820-1312 | 74S02 |
| U15 | 1820-1197 | 74LS00 |
| U17 | 1820-1440 | 74LS299 |
| U18 | 1820-1316 | 74LS196 |
| U19 | 1820-1746 | 74LS175 |
| U20,21,23 | 1820-2019 | 75LS5468 |

(F) REF/GATE GENERATOR

**FIG 10.25**

# FIG. 10.26

EP 0 153 478 B1

FIG. 10.27

FIG. 10.29

TO FIG 10.30B PRETUNE

B PHASE DETECTOR

IF(IN) J3

20MHz REF J2

+5VF
+5VPD
L10
C9 0.1
R27 82.5
R29 133
R26 82.5
R28 133

U6
1 14
Ø_A > Ø_B  A
Ø_B > Ø_A  B
3
4 NC
12
11 NC
7

REFERENCE FILTER
10MHz BANDWIDTH

L2 4.3
R4 511
L1 4.3
R3 511
C1 120p
C31 15p
L4 4.3
C28 120p
C29 15p
C3 100p
C33 10p
L6 3.3
L3 4.3
C2 100p
C34 10p
L5 3.3
R5 215
C32 27p
R7 1000
R6 1000

TP5

6
e

FIG. 10.30A

61

# FIG. 10.30B

FIG. 10.31

FIG 10.32

FIG 10.33